# EUROPEAN PATENT APPLICATION

(11) **EP 4 852 649 A1**
(43) Date of publication of application: **09.12.2026**
(21) Application number: 26157460.2
(22) Date of filing: 10.02.2026
(51) Int. Cl.: H10D 84/01, H10D 30/00, H10D 30/01, H10D 30/43, H10D 84/03, H10D 84/83, H10D 84/85

(54) **SEMICONDUCTOR DEVICES WITH GATE CUTS**

(30) Priority: 04.06.2025 KR 20250072749
(71) Applicant: Samsung Electronics Co., Ltd., Suwon-si, Gyeonggi-do 16677 (KR)
(72) Inventor: KIM, Kyung Min, 16677 Suwon-si (KR); KIM, Ki-Il, 16677 Suwon-si (KR); KIM, Gwan Ho, 16677 Suwon-si (KR); PARK, Sang Duk, 16677 Suwon-si (KR); BAI, Keun Hee, 16677 Suwon-si (KR); HAN, Dong Woo, 16677 Suwon-si (KR)
(74) Representative: Marks & Clerk LLP

(57) **Abstract**

A semiconductor device includes a first gate electrode extending in the second direction on first and second insulating patterns, a lower gate cut disposed between the first insulating pattern and the second insulating pattern, the lower gate cut penetrating the first lower interlayer insulating layer in the third direction, the lower gate cut extending into the first gate electrode, and an upper gate cut having a lower surface being in contact with the lower gate cut, the upper gate cut penetrating the first gate electrode in the third direction, an upper surface of the upper gate cut formed higher than an upper surface of the first gate electrode, wherein at least a portion of the upper gate cut extends in the lower gate cut, and wherein the first gate electrode is separated in the second direction by the lower gate cut and the upper gate cut.

## Description

### BACKGROUND

### 1. Technical Field

The present disclosure relates to a semiconductor device with gate cuts. More particularly, the present disclosure relates to a semiconductor device including a MBCFET^{™} (Multi-Bridge Channel Field Effect Transistor), which is a type of gate all around (GAA) transistor.

### 2. Description of the Related Art

As one of the scaling techniques to increase the density of integrated circuit devices, a multi-gate transistor has been proposed, in which a fin-shaped or nanowire-shaped silicon body is formed on a substrate, and gates are formed on the surface of the silicon body.

Since these multi-gate transistors utilize a three-dimensional channel, scaling may be more easily achieved. Additionally, the current control capability may be improved without increasing the gate length of the multi-gate transistor. Furthermore, the SCE (short channel effect), in which the potential of the channel region is influenced by the drain voltage, may be effectively suppressed.

### SUMMARY

Some aspects of the present disclosure provide semiconductor devices that include a gate cut including a lower gate cut formed from the backside and an upper gate cut formed from the frontside, thereby reducing defects associated with the gate cut.

Some aspects of the present disclosure provide semiconductor devices in which the upper gate cut is at least partially surrounded by the lower gate cut to enable a stable connection between the upper and lower gate cuts.

The aspects of the present disclosure are not limited to those mentioned above, and other aspects and improvements may be clearly understood by those skilled in the art from the following description.

According to some implementations of the present disclosure, there is provided a semiconductor device, comprising a first lower interlayer insulating layer, a first insulating pattern extending in a first direction on an upper surface of the first lower interlayer insulating layer, a second insulating pattern extending in the first direction on the upper surface of the first lower interlayer insulating layer, the second insulating pattern spaced apart from the first insulating pattern in a second direction different from the first direction, a first plurality of nanosheets spaced apart from each other along a third direction perpendicular to each of the first and second directions, wherein the first plurality of nanosheets are on an upper surface of the first insulating pattern, a second plurality of nanosheets spaced apart from each other along the third direction, wherein the second plurality of nanosheets are on an upper surface of the second insulating pattern, and wherein the second plurality of nanosheets are spaced apart from the first plurality of nanosheets along the second direction, a first gate electrode extending in the second direction on the first and second insulating patterns, wherein the first plurality of nanosheets and the second plurality of nanosheets are in the first gate electrode, a lower gate cut between the first insulating pattern and the second insulating pattern, the lower gate cut extending through the first lower interlayer insulating layer in the third direction and extending in the first gate electrode, and an upper gate cut having a lower surface in contact with the lower gate cut, the upper gate cut extending in the first gate electrode in the third direction, wherein an upper surface of the upper gate cut is higher than an upper surface of the first gate electrode, wherein at least a portion of the upper gate cut extends in the lower gate cut, and wherein portions of the first gate electrode are spaced apart from one another along the second direction by the lower gate cut and the upper gate cut.

According to some implementations of the present disclosure, there is provided a semiconductor device, comprising a first lower interlayer insulating layer, a first insulating pattern extending in a first direction on an upper surface of the first lower interlayer insulating layer, a second insulating pattern extending in the first direction on the upper surface of the first lower interlayer insulating layer, wherein the second insulating pattern is spaced apart from the first insulating pattern along a second direction different from the first direction, a first gate electrode extending in the second direction on the first and second insulating patterns, a second gate electrode extending in the second direction on the first and second insulating patterns, the second gate electrode spaced apart from the first gate electrode along the first direction, a lower gate cut between the first insulating pattern and the second insulating pattern, wherein the lower gate cut extends through the first lower interlayer insulating layer in a third direction perpendicular to each of the first and second directions, and wherein the lower gate cut extends in each of the first and second gate electrodes, and an upper gate cut having a lower surface in contact with the lower gate cut, the upper gate cut extending in each of the first and second gate electrodes in the third direction, wherein an upper surface of the upper gate cut is higher than an upper surface of each of the first and second gate electrodes, wherein at least a portion of the upper gate cut extends in the lower gate cut, wherein the lower surface of the upper gate cut is lower than an uppermost surface of the lower gate cut, and wherein portions of the first gate electrode are spaced apart from one another along the second direction by the lower gate cut and the upper gate cut, and wherein portions of the second gate electrode are spaced apart from one another along the second direction by the lower gate cut and the upper gate cut.

According to some implementations of the present disclosure, there is provided a semiconductor device, comprising a lower interlayer insulating layer, a first insulating pattern extending in a first direction on an upper surface of the lower interlayer insulating layer, a second insulating pattern extending in the first direction on the upper surface of the lower interlayer insulating layer, wherein the second insulating pattern is spaced apart from the first insulating pattern along a second direction different from the first direction, a first plurality of nanosheets spaced apart from each other along a third direction perpendicular to each of the first and second directions. wherein the first plurality of nanosheets are on an upper surface of the first insulating pattern, a second plurality of nanosheets spaced apart from each other along the third direction, wherein the second plurality of nanosheets are on an upper surface of the second insulating pattern, and wherein the second plurality of nanosheets are spaced apart from the first plurality of nanosheets along the second direction, a first gate electrode extending in the second direction on the first and second insulating patterns, wherein the first and second plurality of nanosheets are in the first gate electrode, a second gate electrode extending in the second direction on the first and second insulating patterns, wherein the second gate electrode is spaced apart from the first gate electrode along the first direction, a lower gate cut between the first insulating pattern and the second insulating pattern, wherein the lower gate cut extends through the lower interlayer insulating layer in the third direction, and wherein the lower gate cut extends in each of the first and second gate electrodes, a first upper gate cut having a lower surface in contact with the lower gate cut, wherein the first upper gate cut extends in the first gate electrode in the third direction, wherein an upper surface of the first upper gate cut is higher than an upper surface of the first gate electrode, wherein at least a portion of the first upper gate cut extends in the lower gate cut, and wherein the lower surface of the first upper gate cut is lower than an uppermost surface of the lower gate cut, and a second upper gate cut having a lower surface in contact with the lower gate cut, wherein the second upper gate cut extends in the second gate electrode in the third direction, wherein at least a portion of the second upper gate cut extends in the lower gate cut, wherein the lower surface of the second upper gate cut is lower than the uppermost surface of the lower gate cut, and wherein the second upper gate cut is spaced apart from the first upper gate cut along the first direction, wherein portions of the first gate electrode are spaced apart along the second direction by the lower gate cut and the first upper gate cut, and wherein portions of the second gate electrode are spaced apart along the second direction by the lower gate cut and the second upper gate cut, wherein a width of the lower surface of the first upper gate cut in the first direction is smaller than a width of the uppermost surface of the lower gate cut in the first direction, wherein a width of the uppermost surface of the lower gate cut in the first direction is smaller than a width of a lower surface of the lower gate cut in the first direction, and wherein a width of the lower surface of the first upper gate cut in the first direction is smaller than a width of the upper surface of the first upper gate cut in the first direction.

At least some of the above and other features of the invention are set out in the claims.

### BRIEF DESCRIPTION OF THE DRAWINGS

The above and other aspects and features of the present disclosure will become apparent through the following description with reference to the attached drawings, in which:
FIG. 1 is a layout view illustrating an example of a semiconductor device;
FIG. 2 is a cross-sectional view taken along line A-A' of FIG. 1;
FIG. 3 is a cross-sectional view taken along line B-B' of FIG. 1;
FIG. 4 is a cross-sectional view taken along line C-C' of FIG. 1;
FIG. 5 is a cross-sectional view taken along line D-D' of FIG. 1;
FIGS. 6 to 44 are intermediate cross-sectional process views illustrating an example of a method for fabricating a semiconductor device;
FIG. 45 is a cross-sectional view illustrating an example of a semiconductor device;
FIGS. 46 and 47 are cross-sectional views illustrating an example of a semiconductor device;
FIG. 48 is a cross-sectional view illustrating an example of a semiconductor device;
FIG. 49 is a layout view illustrating an example of a semiconductor device;
FIG. 50 is a cross-sectional view taken along line E-E' of FIG. 49;
FIG. 51 is a cross-sectional view taken along line F-F' of FIG. 49; and
FIGS. 52 and 53 are cross-sectional views illustrating an example of a semiconductor device.

### DETAILED DESCRIPTION

In the following description and associated drawings, semiconductor devices are described using the specific example of a transistor, such as an MBCFET^{™} (Multi-Bridge Channel Field Effect Transistor) that includes a nanosheet. However, semiconductor devices within the scope of this disclosure are not limited thereto. For example, the semiconductor device may include a fin-type transistor (FinFET) having a channel region in a fin-shaped pattern, a tunneling transistor (tunneling FET), or a three-dimensional (3D) transistor. As further examples, the semiconductor device may include a bipolar junction transistor or laterally diffused metal-oxide-semiconductor (LDMOS) transistor, etc.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

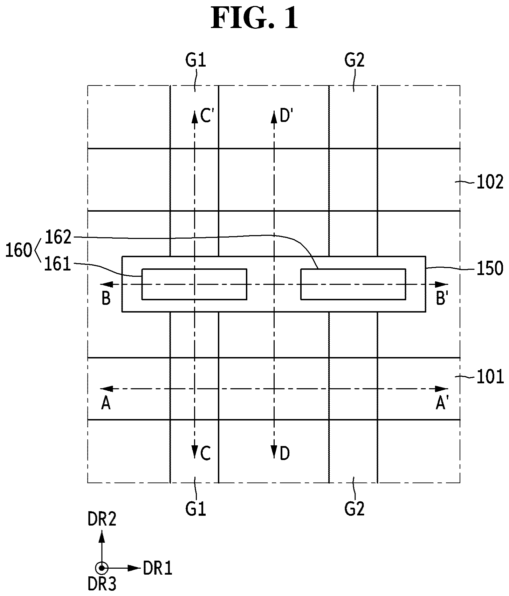

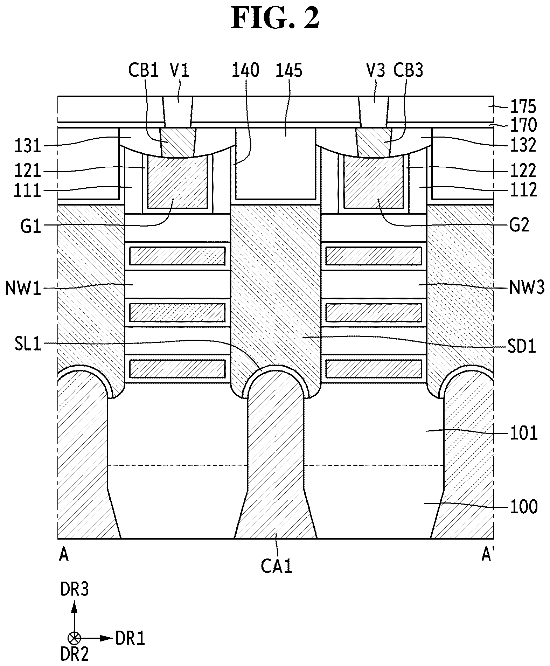

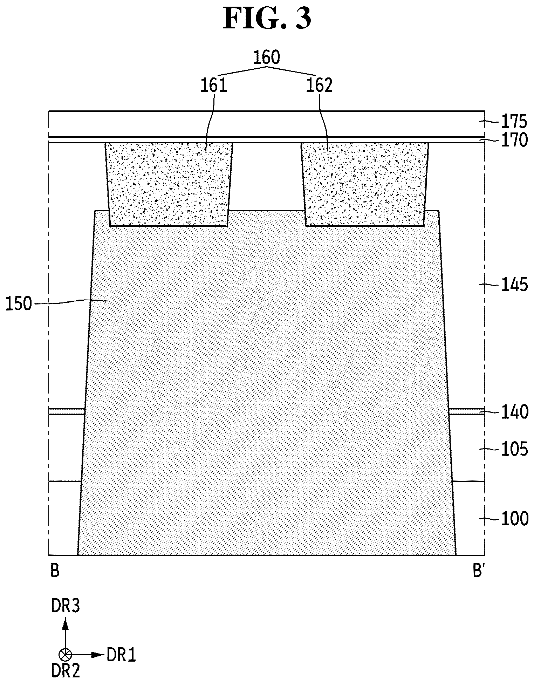

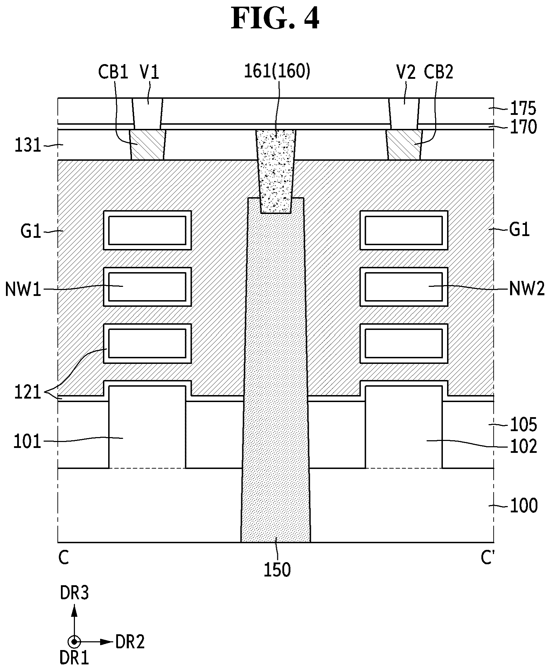

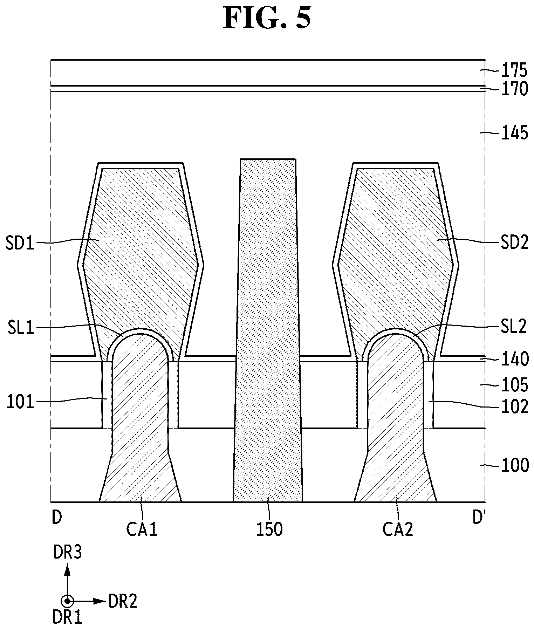

Hereinafter, an example of a semiconductor device will be described with reference to FIGS. 1 to 5. FIG. 1 is a layout view of the semiconductor device. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1. FIG. 5 is a cross-sectional view taken along line D-D' of FIG. 1.

Referring to FIGS. 1 to 5, a semiconductor device includes a first lower interlayer insulating layer 100, first and second insulating patterns 101, 102, a field insulating layer 105, first to third pluralities of nanosheets NW1, NW2, NW3, first and second gate electrodes G1, G2, first and second gate spacers 111, 112, first and second gate insulating layers 121, 122, first and second capping patterns 131, 132, first and second source/drain regions SD1, SD2, a first etching stop layer 140 (otherwise known as a first etch stop layer), a first upper interlayer insulating layer 145, a lower gate cut 150, an upper gate cut 160, first to third gate contacts CB1, CB2, CB3, first and second source/drain contacts CA1, CA2, first and second silicide layers SL1, SL2, a second etching stop layer 170 (otherwise known as a second etch stop layer), a second upper interlayer insulating layer 175, and first to third vias V1, V2, V3.

The first lower interlayer insulating layer 100 may include, for example, at least one of silicon oxide, silicon nitride, silicon oxynitride, and a low-k dielectric material. A low-k dielectric material may be a dielectric material having a dielectric constant that is lower than that of silicon oxide. The low-k dielectric material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylcyCloTetraSiloxane (OMCTS), HexaMethylDiSiloxane (HMDS), TriMethylSilyl Borate (TMSB), DiAcetoxyDitertiaryButoxySiloxane (DADBS), TriMethylSilil Phosphate (TMSP), PolyTetraFluoroEthylene (PTFE), polyimide nanofoams such as polypropylene oxide, TOSZ (Tonen SilaZen), FSG (Fluoride Silicate Glass), CDO (Carbon Doped silicon Oxide), OSG (Organo Silicate Glass), SiLK, amorphous fluorinated carbon, silica aerogels, silica xerogels, mesoporous silica, or combinations thereof, although the present disclosure is not limited thereto.

Hereinafter, a first direction DR1 and a second direction DR2 may be defined as directions parallel to an upper surface of the first lower interlayer insulating layer 100. The second direction DR2 may be defined as a direction different from the first direction DR1. For instance, the second direction DR2 may intersect the first direction DR1. A third direction DR3 may be defined as a direction perpendicular to each of the first direction DR1 and the second direction DR2. That is, the third direction DR3 may be defined as a direction perpendicular to the upper surface of the first lower interlayer insulating layer 100. In some implementations, the first direction DR1 is perpendicular to the second direction DR2. The third direction DR3 may define a height, or vertical, direction of the semiconductor device. "Upper" features may be located further along the third direction DR3 than "lower" features. Similarly, features that are described as being "above" other features may be located further along the third direction DR3 than the other features. It will be appreciated that the directions and relative positions defined herein are defined relative to the structure of the semiconductor device, and therefore need not imply any particular orientation of the semiconductor device in use.

The first insulating pattern 101 may extend in the first direction DR1 on the upper surface of the first lower interlayer insulating layer 100. The second insulating pattern 102 may extend in the first direction DR1 on the upper surface of the first lower interlayer insulating layer 100. The second insulating pattern 102 may be spaced apart from the first insulating pattern 101 in the second direction DR2. As an example, each of the first and second insulating patterns 101 and 102 may protrude in the third direction DR3 from the upper surface of the first lower interlayer insulating layer 100. For example, a lower surface of each of the first and second insulating patterns 101, 102 may be in contact with the upper surface of the first lower interlayer insulating layer 100. As an example, each of the first and second insulating patterns 101, 102 may include the same material as the first lower interlayer insulating layer 100.

The field insulating layer 105 may be disposed on an upper surface of the first lower interlayer insulating layer 100. The field insulating layer 105 may surround sidewalls of the first and second insulating patterns 101, 102. As an example, upper surfaces of the first and second insulating patterns 101, 102 may protrude in the third direction DR3 above an upper surface of the field insulating layer 105. However, the present disclosure is not limited thereto. In some implementations, the upper surfaces of the first and second insulating patterns 101, 102 are formed on the same plane as the upper surface of the field insulating layer 105. The field insulating layer 105 may include, for example, an oxide layer, a nitride layer, an oxynitride layer, or a combination thereof.

A first plurality of nanosheets NW1 may be disposed on the upper surface of the first insulating pattern 101. A second plurality of nanosheets NW2 may be disposed on the upper surface of the second insulating pattern 102. The second plurality of nanosheets NW2 may be spaced apart from the first plurality of nanosheets NW1 in the second direction DR2. A third plurality of nanosheets NW3 may be disposed on the upper surface of the first insulating pattern 101. The third plurality of nanosheets NW3 may be spaced apart from the first plurality of nanosheets NW1 in the first direction DR1. Each of the first to third plurality of nanosheets NW1, NW2, NW3 may include a plurality of nanosheets spaced apart from each other in the third direction DR3 and stacked. A nanosheet may be a structure having a thickness (e.g., in the third direction DR3) of between 1 nm and 100 nm.

In FIGS. 2 and 4, the first to third plurality of nanosheets NW1, NW2, NW3 are shown including three nanosheets spaced apart from each other in the third direction DR3 and stacked (e.g., spaced apart from each other and stacked in the third direction DR3), but the present disclosure is not limited thereto. In some implementations, each of the first to third plurality of nanosheets NW1, NW2, NW3 may include four or more nanosheets spaced apart from each other in the third direction DR3 and stacked (e.g., spaced apart from each other and stacked in the third direction DR3). In some implementations, each of the first to third plurality of nanosheets NW1, NW2, NW3 may include a semiconductor material. In some implementations, each of the first to third plurality of nanosheets NW1, NW2, NW3 may include silicon (Si). However, the present disclosure is not limited thereto. For example, in some implementations, each of the first to third plurality of nanosheets NW1, NW2, NW3 may include silicon germanium (SiGe). Hereinafter, each of the first to third plurality of nanosheets NW1, NW2, NW3 will be described as including silicon (Si).

The first gate electrode G1 may extend in the second direction DR2 over the first and second insulating patterns 101, 102. The first gate electrode G1 may surround each of the first and second pluralities of nanosheets NW1, NW2. The second gate electrode G2 may extend in the second direction DR2 over the first and second insulating patterns 101, 102. The second gate electrode G2 may be spaced apart from the first gate electrode G1 in the first direction DR1. The second gate electrode G2 may surround the third plurality of nanosheets NW3.

As an example, each of the first and second gate electrodes G1, G2 may include a conductive material, such as metal. For example, each of the first and second gate electrodes G1, G2 may include one or more of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. Each of the first and second gate electrodes G1, G2 may instead or additionally include a conductive metal oxide or a conductive metal oxynitride, and/or may include an oxidized form of the above-described materials.

The first gate spacer 111 may extend in the second direction DR2 along both sidewalls of the first gate electrode G1 over upper surfaces of the uppermost nanosheets of the first and second pluralities of nanosheets NW1, NW2 and over the upper surface of the field insulating layer 105. The second gate spacer 112 may extend in the second direction DR2 along both sidewalls of the second gate electrode G2 over the upper surface of the uppermost nanosheet in the third plurality of nanosheets NW3 and over the upper surface of the field insulating layer 105. As an example, each of the first and second gate spacers 111, 112 may include at least one of silicon nitride (SiN), silicon oxynitride (SiON), silicon oxide (SiO₂), silicon carbon oxynitride (SiOCN), silicon boron nitride (SiBN), silicon oxygen boron nitride (SiOBN), silicon oxycarbide (SiOC), and combinations thereof. However, the present disclosure is not limited thereto.

A plurality of first source/drain regions SD1 may be provided (e.g., spaced apart from each other in the first direction DR1). The first source/drain regions SD1 may be disposed on both sides of the first gate electrode G1 and the second gate electrode G2 on the upper surface of the first insulating pattern 101. For example, the first source/drain regions SD1 may be in contact with the sidewalls of the first and third pluralities of nanosheets NW1, NW3 in the first direction DR1. The first source/drain regions SD1 may contact opposite sides of each of the first and third pluralities of nanosheets NW1, NW3. The first plurality of nanosheets NW1 may extend through the first gate electrode G1 in the first direction DR1. The first plurality of nanosheets NW1 may form channels between the first source/drain regions SD1 that contact opposite sides of the first plurality of nanosheets NW1 (e.g., in the first direction DR1). The third plurality of nanosheets NW3 may extend through the second gate electrode G2 in the first direction DR1. The third plurality of nanosheets NW3 may form channels between the first source/drain regions SD1 that contact opposite sides of the third plurality of nanosheets NW3 (e.g., in the first direction DR1). A plurality of second source/drain regions SD2 may be provided (e.g., spaced apart from each other in the first direction DR1). The second source/drain regions SD2 may be disposed on both sides of the first gate electrode G1 and the second gate electrode G2 on the upper surface of the second insulating pattern 102. The second source/drain regions SD2 may may contact opposite sides of the second plurality of nanosheets NW2. The second plurality of nanosheets NW2 may extend through the first gate electrode G1 in the first direction DR1. The second plurality of nanosheets NW2 may form channels between the second source/drain regions SD2 that contact opposite sides of the second plurality of nanosheets NW2 (e.g., in the first direction DR1). As an example, the upper surfaces of the first and second source/drain regions SD1, SD2 may be formed higher than the upper surfaces of the uppermost nanosheets of the first to third plurality of nanosheets NW1, NW2, NW3.

The first gate insulating layer 121 may be disposed between the first gate electrode G1 and the first insulating pattern 101. The first gate insulating layer 121 may be disposed between the first gate electrode G1 and the second insulating pattern 102. The first gate insulating layer 121 may be disposed between the first gate electrode G1 and the field insulating layer 105. The first gate insulating layer 121 may be disposed between the first gate electrode G1 and the first gate spacer 111. The first gate insulating layer 121 may be disposed between the first gate electrode G1 and the first plurality of nanosheets NW1. The first gate insulating layer 121 may be disposed between the first gate electrode G1 and the second plurality of nanosheets NW2. The first gate insulating layer 121 may be disposed between the first gate electrode G1 and the first source/drain regions SD1. The first gate insulating layer 121 may be disposed between the first gate electrode G1 and the second source/drain regions SD2.

The second gate insulating layer 122 may be disposed between the second gate electrode G2 and the first insulating pattern 101. The second gate insulating layer 122 may be disposed between the second gate electrode G2 and the second insulating pattern 102. The second gate insulating layer 122 may be disposed between the second gate electrode G2 and the field insulating layer 105. The second gate insulating layer 122 may be disposed between the second gate electrode G2 and the second gate spacer 112. The second gate insulating layer 122 may be disposed between the second gate electrode G2 and the third plurality of nanosheets NW3. The second gate insulating layer 122 may be disposed between the second gate electrode G2 and the first source/drain regions SD1. The second gate insulating layer 122 may be disposed between the second gate electrode G2 and the second source/drain regions SD2.

As an example, each of the first and second gate insulating layers 121, 122 may include at least one of silicon oxide, silicon oxynitride, silicon nitride, or a high-k dielectric material. A high-k dielectric material may be a dielectric material having a dielectric constant greater than that of silicon oxide. The high-k dielectric material may include, for example, at least one of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

The semiconductor device may include a negative capacitance (NC) FET utilizing a negative capacitor. For example, each of the first and second gate insulating layers 121, 122 may include a ferroelectric material layer exhibiting ferroelectric properties and a paraelectric material layer exhibiting paraelectric properties.

The ferroelectric material layer may have a negative capacitance, while the paraelectric material layer may have a positive capacitance. For example, when two or more capacitors are connected in series and the capacitance of each of the capacitors is positive, the overall capacitance becomes less than that of each individual capacitor. On the other hand, if at least one of the capacitances of two or more capacitors connected in series is negative, the overall capacitance may remain positive and be greater than the absolute value of each individual capacitance.

When the ferroelectric material layer having a negative capacitance is connected in series with the paraelectric material layer having a positive capacitance, the overall capacitance value of the ferroelectric material layer and the paraelectric material layer connected in series may increase. By utilizing the increase in overall capacitance value, the transistor including the ferroelectric material layer may have a subthreshold swing (SS) less than 60 mV/decade at room temperature (e.g., at 20°C).

The ferroelectric material layer may have ferroelectric properties. The ferroelectric material layer may include, for example, at least one of hafnium oxide, hafnium zirconium oxide, barium strontium titanium oxide, barium titanium oxide, and lead zirconium titanium oxide. As an example, the hafnium zirconium oxide may be a material in which zirconium (Zr) is doped into hafnium oxide. As another example, the hafnium zirconium oxide may be a compound of hafnium (Hf) and zirconium (Zr) combined with oxygen (O).

The ferroelectric material layer may further include a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material layer may vary depending on the ferroelectric material included therein.

As an example, if the ferroelectric material layer includes hafnium oxide, the dopant included in the ferroelectric material layer may include at least one of gadolinium (Gd), silicon (Si), zirconium (Zr), aluminum (Al), and yttrium (Y).

If the dopant is aluminum (Al), the ferroelectric material layer may include from about 3 to about 8 at% (atomic %) (e.g., 3 to 8 at%) of aluminum. In this case, the ratio of the dopant may be the ratio of aluminum to the sum of hafnium and aluminum.

If the dopant is silicon (Si), the ferroelectric material layer may include 2 to 10 at% of silicon. If the dopant is yttrium (Y), the ferroelectric material layer may include 2 to 10 at% of yttrium. If the dopant is gadolinium (Gd), the ferroelectric material layer may include 1 to 7 at% of gadolinium. If the dopant is zirconium (Zr), the ferroelectric material layer may include 50 to 80 at% of zirconium.

The paraelectric material layer may have paraelectric properties. The paraelectric material layer may include, for example, at least one or more of silicon oxide and a metal oxide having a high-k dielectric constant (e.g., a dielectric constant that is higher than that of silicon oxide). The metal oxide included in the paraelectric material layer may include, for example, at least one of hafnium oxide, zirconium oxide, and aluminum oxide, but is not limited thereto.

The ferroelectric material layer and the paraelectric material layer may include the same material. While the ferroelectric material layer may have ferroelectric properties, the paraelectric material layer may not have ferroelectric properties. For example, if both the ferroelectric material layer and the paraelectric material layer include hafnium oxide, the crystal structure of the hafnium oxide included in the ferroelectric material layer may be different from the crystal structure of the hafnium oxide included in the paraelectric material layer.

The ferroelectric material layer may have a thickness that enables the ferroelectric properties. For example, the thickness of the ferroelectric material layer may be in a range from about 0.5 to about 10 nm (e.g., of 0.5 to 10 nm), but is not limited thereto. Since the critical thickness for exhibiting ferroelectric properties may vary depending on the ferroelectric material, the thickness of the ferroelectric material layer may also vary depending on the specific ferroelectric material used.

As an example, each of the first and second gate insulating layers 121, 122 may include a single ferroelectric material layer. As another example, each of the first and second gate insulating layers 121, 122 may include a plurality of ferroelectric material layers spaced apart from each other. Each of the first and second gate insulating layers 121, 122 may have a stacked structure in which a plurality of ferroelectric material layers and a plurality of paraelectric material layers are alternately stacked on each other.

The first etching stop layer 140 may be disposed on the upper surface of the field insulating layer 105. The first etching stop layer 140 may be disposed on the sidewalls of the first and second gate spacers 111, 112 in the first direction DR1. The first etching stop layer 140 may be disposed on the upper surfaces of the first and second source/drain regions SD1, SD2. The first etching stop layer 140 may also be disposed on the sidewalls of the first and second source/drain regions SD1, SD2 in the second direction DR2. As an example, the first etching stop layer 140 may be formed conformally. As an example, the first etching stop layer 140 may include at least one of aluminum oxide, aluminum nitride, hafnium oxide, zirconium oxide, silicon oxide, silicon nitride, silicon oxynitride, and a low-k dielectric material.

The first capping pattern 131 may extend in the second direction DR2 on each of the first gate spacer 111, the first gate insulating layer 121, and the first gate electrode G1. The first capping pattern 131 may be in contact with the upper surface of the first gate electrode G1. The second capping pattern 132 may extend in the second direction DR2 on each of the second gate spacer 112, the second gate insulating layer 122, and the second gate electrode G2. The second capping pattern 132 may be in contact with the upper surface of the second gate electrode G2. As an example, the lower surfaces of the first and second capping patterns 131, 132 may be in contact with the first etching stop layer 140. However, the present disclosure is not limited thereto. In some implementations, the sidewalls of the first and second capping patterns 131, 132 may also be in contact with the first etching stop layer 140. As an example, each of the first and second capping patterns 131, 132 may include at least one of silicon nitride (SiN), silicon oxynitride (SiON), silicon oxide (SiO₂), silicon carbonitride (SiCN), silicon oxycarbonitride (SiOCN), and combinations thereof.

The first upper interlayer insulating layer 145 may be disposed on the first etching stop layer 140. The first upper interlayer insulating layer 145 may be disposed on sidewalls of the first and second capping patterns 131, 132. The first upper interlayer insulating layer 145 may cover the first and second source/drain regions SD1, SD2 on the field insulating layer 105. As an example, the upper surface of the first upper interlayer insulating layer 145 may be formed on the same plane as the upper surfaces of the first and second capping patterns 131, 132. However, the present disclosure is not limited thereto. For example, the first upper interlayer insulating layer 145 may include at least one of silicon oxide, silicon nitride, silicon oxynitride, and a low-k dielectric material.

The first source/drain contact CA1 may be disposed below each of the plurality of first source/drain regions SD1. The first source/drain contact CA1 may penetrate the first lower interlayer insulating layer 100 and the first insulating pattern 101 in the third direction DR3. As an example, at least a portion of the first source/drain contact CA1 may extend into the first source/drain region SD1 (e.g., into a corresponding first source/drain region SD1). The first source/drain contact CA1 may be connected to (e.g., may contact and/or may be electrically connected to) the first source/drain region SD1. A plurality of first source/drain contacts CA1 may be provided (e.g., spaced apart from each other in the first direction DR1). Each source/drain contact CA1 may contact a corresponding first source/drain region SD1 of the first source drain regions SD1. The second source/drain contact CA2 may be disposed below the second source/drain region SD2. The second source/drain contact CA2 may penetrate the first lower interlayer insulating layer 100 and the second insulating pattern 102 in the third direction DR3. As an example, at least a portion of the second source/drain contact CA2 may extend into the second source/drain region SD2 (e.g., into a corresponding second source/drain region SD2). The second source/drain contact CA2 may be connected to (e.g., may contact and/or may be electrically connected to) the second source/drain region SD2. A plurality of second source/drain contacts CA2 may be provided (e.g., spaced apart from each other in the first direction DR1). Each source/drain contact CA2 may contact a corresponding second source/drain region SD2 of the second source drain regions SD2.

As an example, the lower surfaces of the first and second source/drain contacts CA1, CA2 may be formed on the same plane as the lower surface of the first lower interlayer insulating layer 100. In FIGS. 2 and 5, each of the first and second source/drain contacts CA1, CA2 is shown as being formed as a single layer, but the present disclosure is not limited thereto. In some implementations, the first and second source/drain contacts CA1, CA2 may be formed as multiple layers. Each of the first and second source/drain contacts CA1, CA2 may include a conductive material. A first silicide layer SL1 may be disposed along the interface between the (e.g., each) first source/drain region SD1 and the (e.g., each) first source/drain contact CA1. A second silicide layer SL2 may be disposed along the interface between the (e.g., each) second source/drain region SD2 and the (e.g., each) second source/drain contact CA2. As an example, each of the first and second silicide layers SL1, SL2 may include a metal silicide material.

The lower gate cut 150 may extend in the first direction DR1 between the first insulating pattern 101 and the second insulating pattern 102. The lower gate cut 150 may be spaced apart from each of the first insulating pattern 101 and the second insulating pattern 102 in the second direction DR2. As an example, the lower gate cut 150 may penetrate the first lower interlayer insulating layer 100, the field insulating layer 105, the first gate insulating layer 121, and the second gate insulating layer 122 in the third direction DR3 to extend into the first and second gate electrodes G1, G2. The lower gate cut 150 may penetrate the first lower interlayer insulating layer 100, the field insulating layer 105, and the first etching stop layer 140 in the third direction DR3 to extend into the first upper interlayer insulating layer 145.

As an example, the lower gate cut 150 may be disposed between the first plurality of nanosheets NW1 and the second plurality of nanosheets NW2. The lower gate cut 150 may be spaced apart from each of the first and second pluralities of nanosheets NW1, NW2 in the second direction DR2. As an example, the uppermost surface of the lower gate cut 150 may be formed higher than the upper surfaces of the uppermost nanosheets of the first and second pluralities of nanosheets NW1, NW2. The lower gate cut 150 may be disposed between the first source/drain contact CA1 and the second source/drain contact CA2. The lower gate cut 150 may be spaced apart from each of the first and second source/drain contacts CA1, CA2 in the second direction DR2. The lower gate cut 150 may be disposed between the first source/drain regions SD1 and the second source/drain regions SD2. The lower gate cut 150 may be spaced apart from each of the first and second source/drain regions SD1, SD2 in the second direction DR2.

As an example, the lower surface of the lower gate cut 150 may be formed on the same plane as the lower surface of the first lower interlayer insulating layer 100. The sidewall of the lower gate cut 150 in the first direction DR1 may be in contact with the first upper interlayer insulating layer 145. The upper interlayer insulating layer 145 may be in contact with sidewalls of the lower gate cut 150 that are opposite one another along the first direction DR1. The sidewall of the lower gate cut 150 in the second direction DR2 may be in contact with each of the first and second gate electrodes G1, G2. The sidewall of the lower gate cut 150 in the second direction DR2 may be in contact with the first upper interlayer insulating layer 145. As an example, between the first plurality of nanosheets NW1 and the second plurality of nanosheets NW2, the uppermost surface of the lower gate cut 150 may be in contact with the first gate electrode G1. Between the first source/drain regions SD1 and the second source/drain regions SD2, the uppermost surface of the lower gate cut 150 may be in contact with the first upper interlayer insulating layer 145.

As an example, the width of the uppermost surface of the lower gate cut 150 in the first direction DR1 may be smaller than the width of the lower surface of the lower gate cut 150 in the first direction DR1. The width of the lower gate cut 150 in the first direction DR1 may continuously decrease as it becomes closer to (e.g., extends towards) the uppermost surface of the lower gate cut 150. The width of the uppermost surface of the lower gate cut 150 in the second direction DR2 may be smaller than the width of the lower surface of the lower gate cut 150 in the second direction DR2. The width of the lower gate cut 150 in the second direction DR2 may continuously decrease as it becomes closer to (e.g., extends towards) the uppermost surface of the lower gate cut 150. The lower gate cut 150 may include an insulating material. For example, the lower gate cut 150 may include at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), and combinations thereof. However, the present disclosure is not limited thereto.

The upper gate cut 160 may be disposed on the upper surface of the lower gate cut 150. The lower surface of the upper gate cut 160 may be in contact with the lower gate cut 150. The upper gate cut 160 may penetrate each of the first and second gate electrodes G1, G2 in the third direction DR3. The upper gate cut 160 may penetrate each of the first and second capping patterns 131, 132 in the third direction DR3. As an example, the upper surface of the upper gate cut 160 may be formed higher than the upper surfaces of the first and second gate electrodes G1, G2. As an example, the upper surface of the upper gate cut 160 may be formed on the same plane as the upper surfaces of the first and second capping patterns 131, 132. As an example, the upper surface of the upper gate cut 160 may be formed on the same plane as the upper surface of the first upper interlayer insulating layer 145. As an example, the lower surface of the upper gate cut 160 may be formed lower than the uppermost surface of the lower gate cut 150.

As an example, at least a portion of the sidewall of the upper gate cut 160 in the first direction DR1 may be surrounded by the lower gate cut 150. Additionally, at least a portion of the sidewall of the upper gate cut 160 in the second direction DR2 may be surrounded by the lower gate cut 150. For example, at least a portion of the sidewall of the upper gate cut 160 in the first direction DR1 may be in contact with the lower gate cut 150. Additionally, at least a portion of the sidewall of the upper gate cut 160 in the second direction DR2 may be in contact with the lower gate cut 150. As an example, the sidewall of the upper gate cut 160 in the first direction DR1 may be in contact with the first upper interlayer insulating layer 145. The upper interlayer insulating layer 145 may be in contact with sidewalls of the upper gate cut 160 that are opposite one another along the first direction DR1. The sidewall of the upper gate cut 160 in the second direction DR2 may be in contact with each of the first and second gate electrodes G1, G2 and with each of the first and second capping patterns 131, 132.

As an example, the width of the lower surface of the upper gate cut 160 in the first direction DR1 may be smaller than the width of the uppermost surface of the lower gate cut 150 in the first direction DR1. The width of the lower surface of the upper gate cut 160 in the second direction DR2 may be smaller than the width of the uppermost surface of the lower gate cut 150 in the second direction DR2. As an example, the width of the lower surface of the upper gate cut 160 in the first direction DR1 may be smaller than the width of the upper surface of the upper gate cut 160 in the first direction DR1. The width of the lower surface of the upper gate cut 160 in the second direction DR2 may be smaller than the width of the upper surface of the upper gate cut 160 in the second direction DR2. The width of the upper gate cut 160 in the second direction DR2 may continuously decrease as it becomes closer to (e.g., extends towards) the upper surface of the upper gate cut 160.

As an example, each of the first and second gate electrodes G1, G2 may be separated in the second direction DR2 by the lower gate cut 150 and the upper gate cut 160. For instance, the first gate electrode G1 may be separated into two portions by the lower gate cut 150 and the upper gate cut 160. The lower gate cut 150 and the upper gate cut 160 may insulate the separate portions of the first gate electrode G1 from each other. Similarly, the second gate electrode G2 may be separated into two portions by the lower gate cut 150 and the upper gate cut 160. The lower gate cut 150 and the upper gate cut 160 may insulate the separate portions of the second gate electrode G1 from each other. Each of the first and second capping patterns 131, 132 may be separated in the second direction DR2 by the lower gate cut 150 and the upper gate cut 160. Although not shown, each of the first and second gate spacers 111, 112 may be separated in the second direction DR2 by the lower gate cut 150 and the upper gate cut 160. The upper gate cut 160 may include an insulating material. For example, the upper gate cut 160 may include at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), and combinations thereof. However, the present disclosure is not limited thereto.

In one embodiment, the upper gate cut 160 may include a first upper gate cut 161 and a second upper gate cut 162. The second upper gate cut 162 may be spaced apart from the first upper gate cut 161 in the first direction DR1. The lower gate cut 150 and the first upper gate cut 161 may separate the first gate electrode G1 in the second direction DR2 (e.g., into separate portions). The lower gate cut 150 and the second upper gate cut 162 may separate the second gate electrode G2 in the second direction DR2 (e.g., into separate portions). As an example, the lower surfaces of the first and second upper gate cuts 161, 162 may be in contact with the lower gate cut 150. As an example, the sidewalls of the first and second upper gate cuts 161, 162 in the first direction DR1 may be in contact with the first upper interlayer insulating layer 145. The upper interlayer insulating layer 145 may be in contact with sidewalls of the first upper gate cut 161 that are opposite one another along the first direction DR1. The upper interlayer insulating layer 145 may be in contact with sidewalls of the second upper gate cut 162 that are opposite one another along the first direction DR1. As an example, between the first upper gate cut 161 and the second upper gate cut 162, the first upper interlayer insulating layer 145 may be in contact with the upper surface of the lower gate cut 150. Reference to an upper surface, a lower surface and/or a sidewall of the upper gate cut 160 may refer to upper surface(s), lower surface(s) and/or sidewall(s) of one or both of the first upper gate cut 161 and the second upper gate cut 162.

As an example, the first upper gate cut 161 may penetrate the first gate electrode G1 and the first capping pattern 131 in the third direction DR3. The upper surface of the first upper gate cut 161 may be formed higher than the upper surface of the first gate electrode G1. At least a portion of the sidewall of the first upper gate cut 161 may be surrounded by the lower gate cut 150. The lower surface of the first upper gate cut 161 may be formed lower than the uppermost surface of the lower gate cut 150. As an example, the second upper gate cut 162 may penetrate the second gate electrode G2 and the second capping pattern 132 in the third direction DR3. The upper surface of the second upper gate cut 162 may be formed higher than the upper surface of the second gate electrode G2. At least a portion of the sidewall of the second upper gate cut 162 may be surrounded by the lower gate cut 150. The lower surface of the second upper gate cut 162 may be formed lower than the uppermost surface of the lower gate cut 150.

As an example, the width of the lower surface of the first upper gate cut 161 in the first direction DR1 may be smaller than the width of the uppermost surface of the lower gate cut 150 in the first direction DR1. The width of the lower surface of the first upper gate cut 161 in the second direction DR2 may be smaller than the width of the uppermost surface of the lower gate cut 150 in the second direction DR2. The width of the lower surface of the second upper gate cut 162 in the first direction DR1 may be smaller than the width of the uppermost surface of the lower gate cut 150 in the first direction DR1. The width of the lower surface of the second upper gate cut 162 in the second direction DR2 may be smaller than the width of the uppermost surface of the lower gate cut 150 in the second direction DR2. As an example, the width of the lower surface of the first upper gate cut 161 in the first direction DR1 may be smaller than the width of the upper surface of the first upper gate cut 161 in the first direction DR1. The width of the lower surface of the first upper gate cut 161 in the second direction DR2 may be smaller than the width of the upper surface of the first upper gate cut 161 in the second direction DR2. The width of the lower surface of the second upper gate cut 162 in the first direction DR1 may be smaller than the width of the upper surface of the second upper gate cut 162 in the first direction DR1. The width of the lower surface of the second upper gate cut 162 in the second direction DR2 may be smaller than the width of the upper surface of the second upper gate cut 162 in the second direction DR2.

Each of the first and second gate contacts CB1, CB2 may penetrate the first capping pattern 131 in the third direction DR3 to be connected to the first gate electrode G1. As an example, the first gate contact CB1 may be disposed on a first sidewall of the upper gate cut 160. The second gate contact CB2 may be disposed on a second sidewall of the upper gate cut 160 that is opposite to the first sidewall in the second direction DR2. The third gate contact CB3 may penetrate the second capping pattern 132 in the third direction DR3 to be connected to the second gate electrode G2. The third gate contact CB3 may be located on the first sidewall of the upper gate cut 160. As an example, each of the first to third gate contacts CB1, CB2, CB3 may be formed on the same plane as upper surfaces of the first and second capping patterns 131, 132. However, the relative arrangement is not limited thereto. Each of the first to third gate contacts CB1, CB2, CB3 may include a conductive material. The first capping pattern 131 may be located between the upper gate cut 160 and each of the first and second gate contacts CB1, CB2. The second capping pattern 132 may be located between the upper gate cut 160 and the third gate contact CB3.

The second etching stop layer 170 may be disposed on the upper surfaces of the first to third gate contacts CB1, CB2, CB3, the first and second capping patterns 131, 132, the first upper interlayer insulating layer 145, and the upper gate cut 160. In FIGS. 2 to 5, the second etching stop layer 170 is shown as being formed as a single layer, but the present disclosure is not limited thereto. In some implementations, the second etching stop layer 170 may be formed as a multilayer structure. As an example, the second etching stop layer 170 may include at least one of aluminum oxide, aluminum nitride, hafnium oxide, zirconium oxide, silicon oxide, silicon nitride, silicon oxynitride, and a low-k dielectric material.

The second upper interlayer insulating layer 175 may be disposed on the second etching stop layer 170. As an example, the second upper interlayer insulating layer 175 may include at least one of silicon oxide, silicon nitride, silicon oxynitride, and a low-k dielectric material. A first via V1 may penetrate the second upper interlayer insulating layer 175 and the second etching stop layer 170 in the third direction DR3 to be connected to the first gate contact CB1. A second via V2 may penetrate the second upper interlayer insulating layer 175 and the second etching stop layer 170 in the third direction DR3 to be connected to the second gate contact CB2. A third via V3 may penetrate the second upper interlayer insulating layer 175 and the second etching stop layer 170 in the third direction DR3 to be connected to the third gate contact CB3. Each of the first to third vias V1, V2, V3 may include a conductive material.

In accordance with the foregoing description, in some implementations, the gate cuts 150, 160 separating gate electrodes G1, G2 may include the lower gate cut 150 and the upper gate cut 160. The lower gate cut 150 may be formed to penetrate the first lower interlayer insulating layer 100, and the upper gate cut 160 may be formed to penetrate the first upper interlayer insulating layer 145. Accordingly, in some implementations, defects associated with the gate cut may be reduced by securing a process margin, compared to a structure in which the gate cut is formed as an integral structure. Additionally, in some implementations, the lower gate cut 150 is formed after forming the upper gate cut 160, and at least a portion of the sidewall of the upper gate cut 160 may be surrounded by the lower gate cut 150. As a result, in some implementations, the lower gate cut 150 may be more stably connected to the upper gate cut 160.

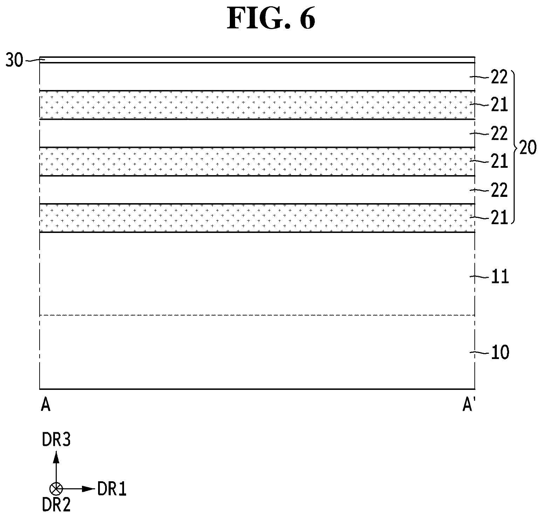

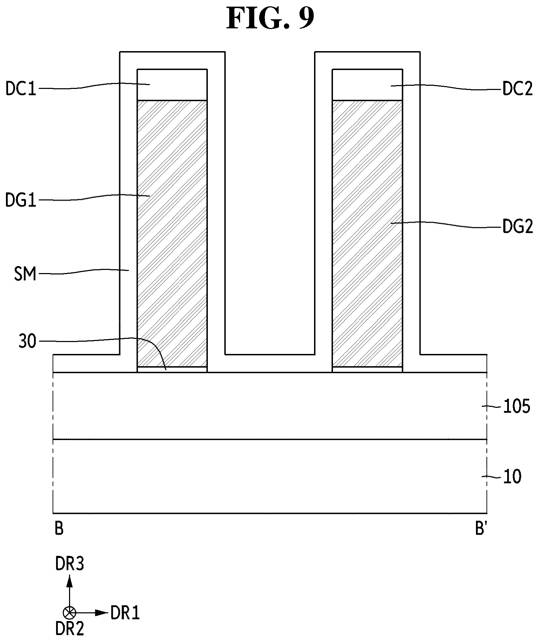

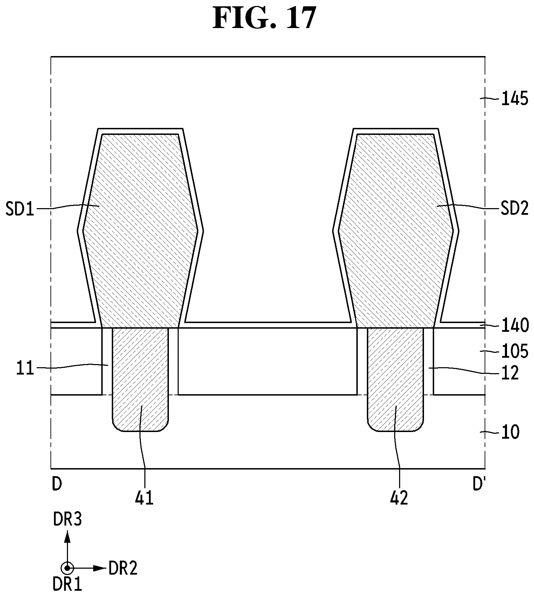

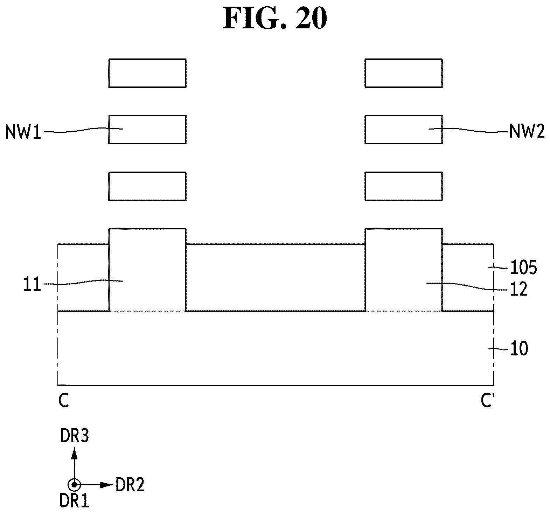

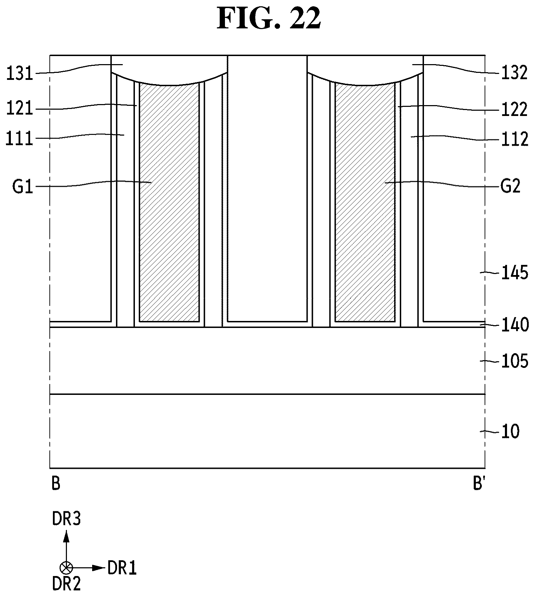

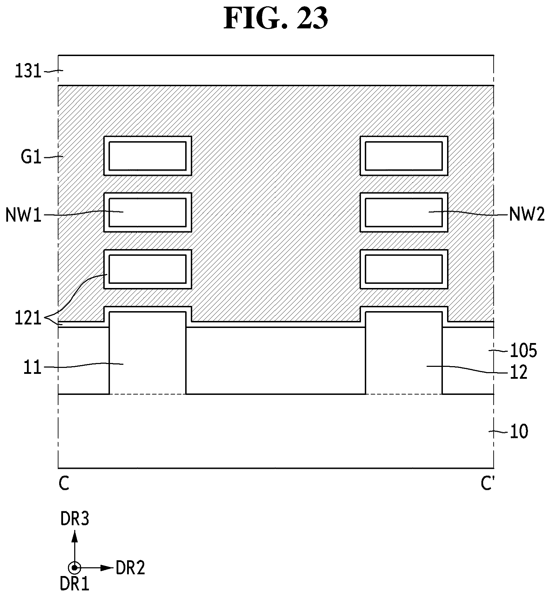

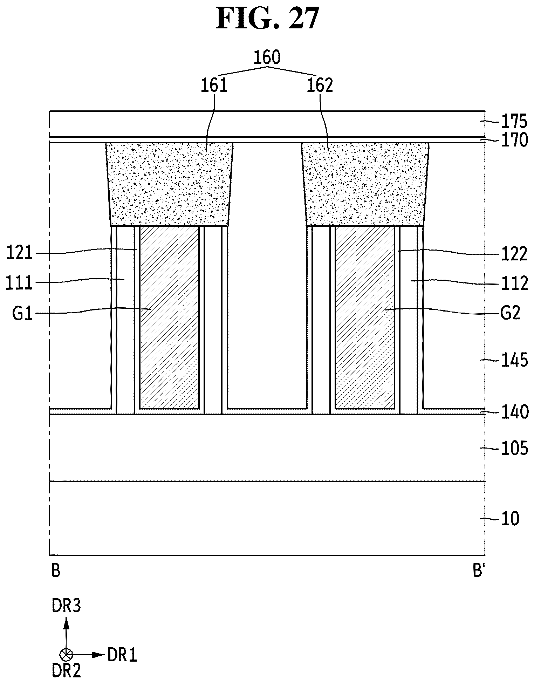

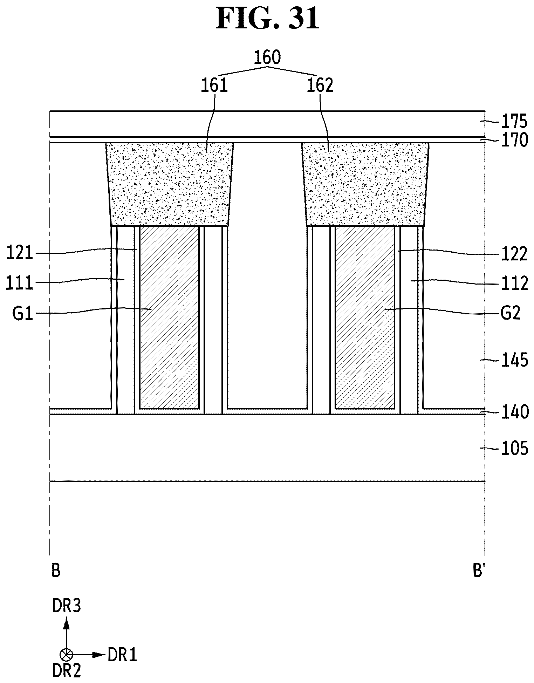

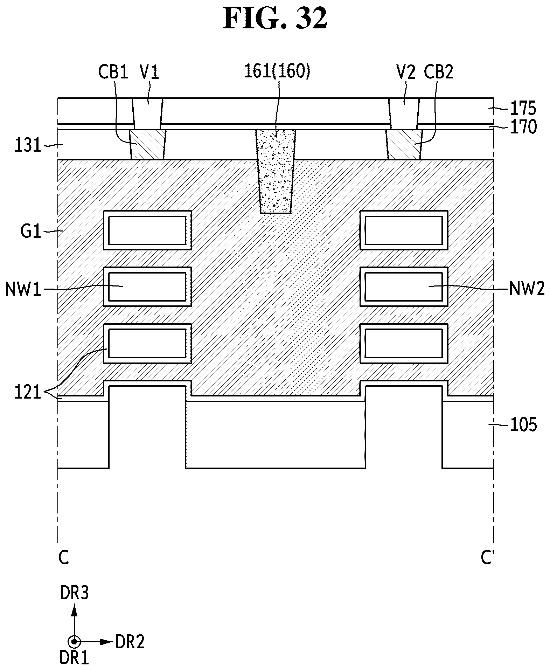

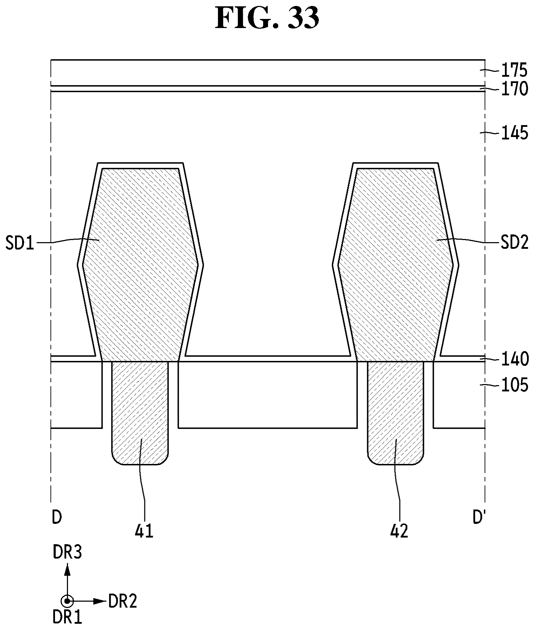

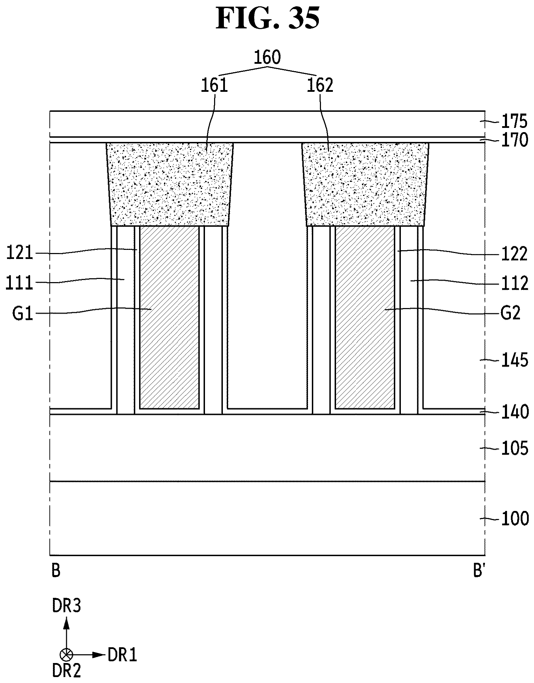

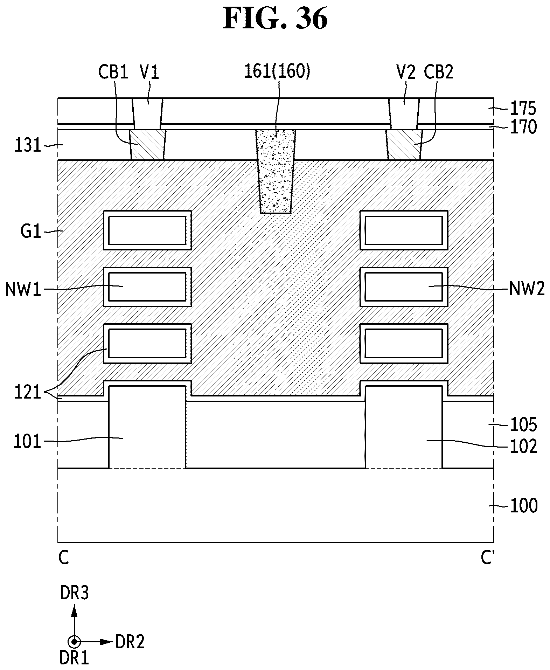

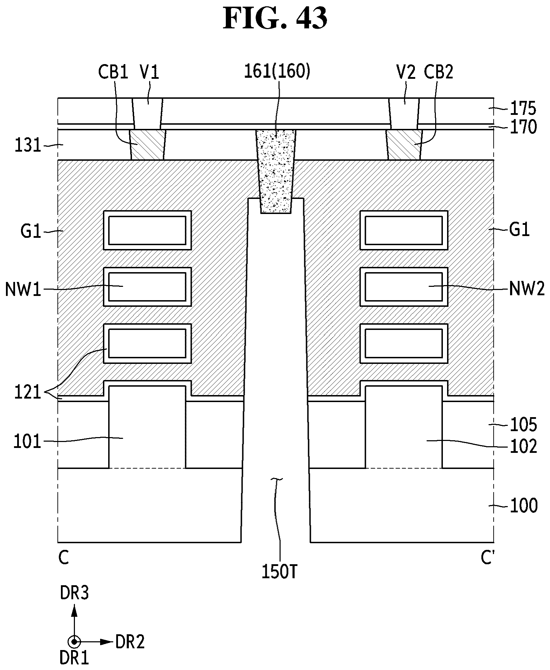

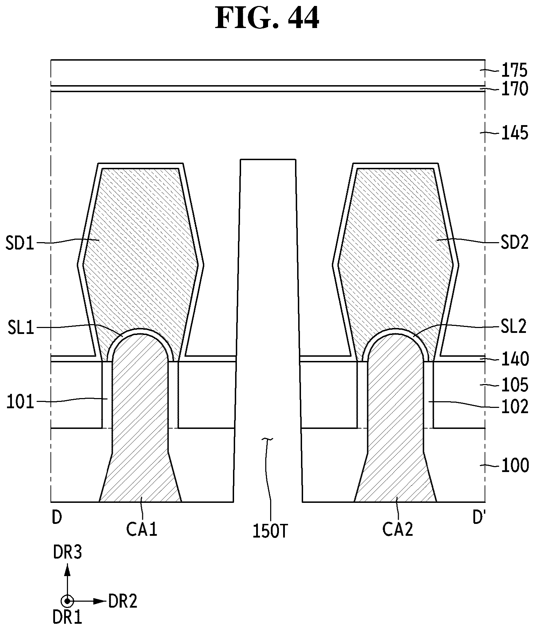

Hereinafter, an example of a method for fabricating a semiconductor device (e.g., the fabrication device described with respect to FIGS. 1 to 5) will be described with reference to FIGS. 6 to 44. FIGS. 6 to 44 are intermediate cross-sectional process views along the lines labeled in FIG. 1.

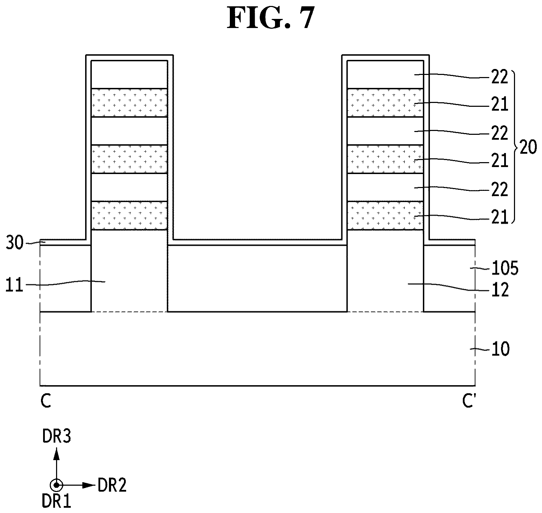

Referring to FIGS. 6 and 7, a substrate 10 may be provided. The substrate 10 may be a silicon substrate or a silicon-on-insulator (SOI) substrate. As another example, the substrate 10 may include silicon germanium, silicon germanium-on-insulator (SGOI), indium antimonide, lead telluride compound, indium arsenide, indium phosphide, gallium arsenide, or gallium antimonide, but the present disclosure is not limited thereto.

Subsequently, a stacked structure 20 may be formed on the upper surface of the substrate 10. The stacked structure 20 may include a first semiconductor layer 21 and a second semiconductor layer 22 alternately stacked on the upper surface of the substrate 10. As an example, the first semiconductor layer 21 may be formed as the lowermost layer of the stacked structure 20, and the second semiconductor layer 22 may be formed as the uppermost layer of the stacked structure 20. However, the present disclosure is not limited thereto. In some implementations, the first semiconductor layer 21 may also be formed as the uppermost layer of the stacked structure 20. As an example, the first semiconductor layer 21 may include silicon germanium (SiGe). As an example, the second semiconductor layer 22 may include silicon (Si).

Next, a portion of the stacked structure 20 may be etched. While the stacked structure 20 is being etched, a portion of the substrate 10 may also be etched. Through this etching process, the first and second active patterns 11, 12 may be defined under the stacked structure 20 on the upper surface of the substrate 10. Each of the first and second active patterns 11, 12 may protrude from the upper surface of the substrate 10 in the third direction DR3. Each of the first and second active patterns 11, 12 may extend in the first direction DR1. The second active pattern 12 may be spaced apart from the first active pattern 11 in the second direction DR2. The first and second active patterns 11, 12 may be formed of a semiconductor material.

Thereafter, the field insulating layer 105 may be formed on the upper surface of the substrate 10. The field insulating layer 105 may surround the sidewalls of the first and second active patterns 11, 12. As an example, the upper surfaces of the first and second active patterns 11, 12 may be formed higher than the upper surface of the field insulating layer 105. Subsequently, a pad oxide layer 30 may be formed to cover the upper surface of the field insulating layer 105, the exposed sidewalls of the first and second active patterns 11, 12, and the sidewalls and the upper surface of the stacked structure 20. As an example, the pad oxide layer 30 may be formed conformally. The pad oxide layer 30 may include silicon oxide (SiO₂), for example.

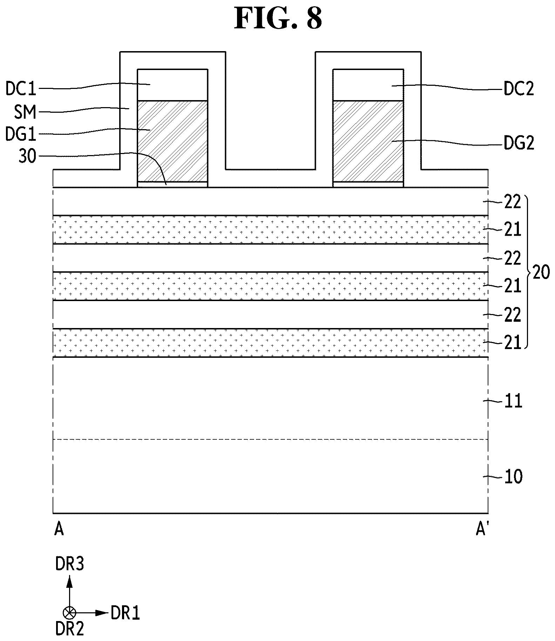

Referring to FIGS. 8 to 11, first and second dummy gates DG1, DG2 and first and second dummy capping patterns DC1, DC2 which extend in the second direction DR2 on the pad oxide layer 30, may be formed over the stacked structure 20 and the field insulating layer 105. As an example, the second dummy gate DG2 may be spaced apart from the first dummy gate DG1 in the first direction DR1. The first dummy capping pattern DC1 may be disposed on the first dummy gate DG1. The second dummy capping pattern DC2 may be disposed on the second dummy gate DG2. While the first and second dummy gates DG1, DG2 and the first and second dummy capping patterns DC1, DC2 are being formed, the remaining portion of the pad oxide layer 30, except for regions overlapping the first and second dummy gates DG1, DG2 in the third direction DR3 on the substrate 10, may be removed.

Next, a spacer material layer SM may be formed to cover sidewalls of the first and second dummy gates DG1, DG2, sidewalls and upper surfaces of the first and second dummy capping patterns DC1, DC2, the exposed sidewalls and upper surface of the stacked structure 20, and the upper surface of the field insulating layer 105. As an example, the spacer material layer SM may be formed conformally. As an example, the spacer material layer SM may include at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof.

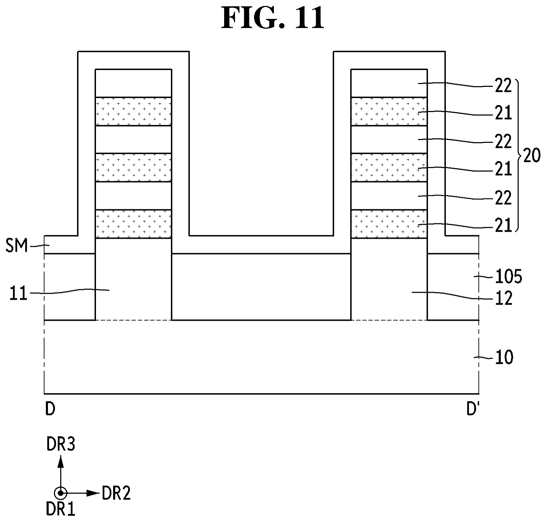

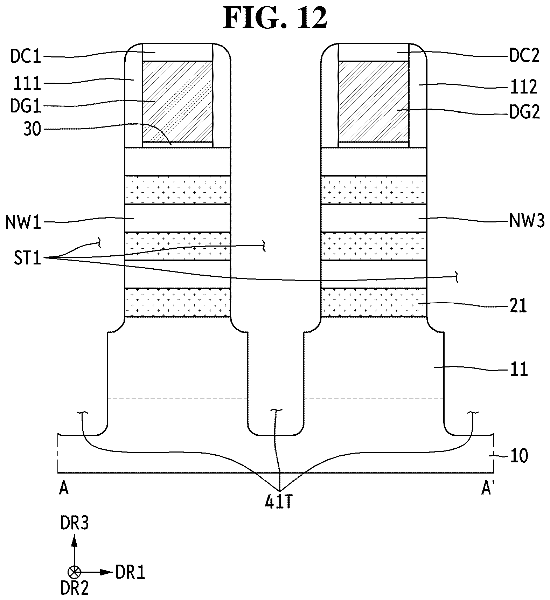

Referring to FIGS. 12 to 14, source/drain trenches ST1 may be formed by etching the stacked structure 20 (see FIGS. 8 and 11) using the first and second dummy gates DG1, DG2 and the first and second dummy capping patterns DC1, DC2 as masks. The first source/drain trenches ST1 may be formed on both sides of each of the first and second dummy gates DG1 and DG2 over the first active pattern 11. Second source/drain trenches may be formed on both sides of each of the first and second dummy gates DG1, DG2 over the second active pattern 12.

In addition, a first sacrificial pattern trench 41T may be formed below each first source/drain trench ST1, and a second sacrificial pattern trench 42T may be formed below each second source/drain trench. As an example, the first sacrificial pattern trenches 41T may be formed within the first active pattern 11 and the substrate 10. The second sacrificial pattern trenches 42T may be formed within the second active pattern 12 and the substrate 10. As an example, the substrate 10 may be exposed on the lower surface of each of the first and second sacrificial pattern trenches 41T, 42T.

As an example, while the first source/drain trenches ST1 and the second source/drain trenches are formed, the spacer material layer SM (see FIGS. 8 to 10) formed on the upper surfaces of the first and second dummy capping patterns DC1, DC2 and portions of the first and second dummy capping patterns DC1, DC2 may be etched. The spacer material layer SM (see FIGS. 8 to 10) remaining on the sidewalls of the first and second dummy capping patterns DC1, DC2 and the first and second dummy gates DG1, DG2 may be defined as the first and second gate spacers 111, 112.

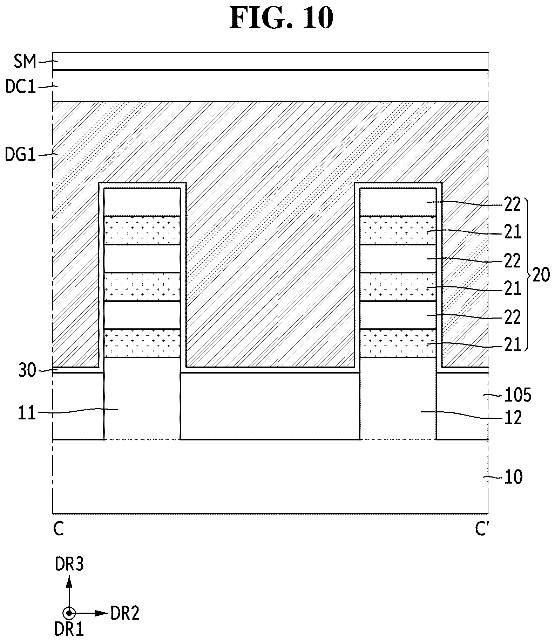

As an example, after the first source/drain trenches ST1 are formed, the second semiconductor layer 22 (see FIGS. 8 and 10) remaining under the first dummy gate DG1 on the first active pattern 11 may be defined as the first plurality of nanosheets NW1. After the first source/drain trenches ST1 are formed, the second semiconductor layer 22 (see FIGS. 8 and 10) remaining under the second dummy gate DG2 on the first active pattern 11 may be defined as the third plurality of nanosheets NW3.

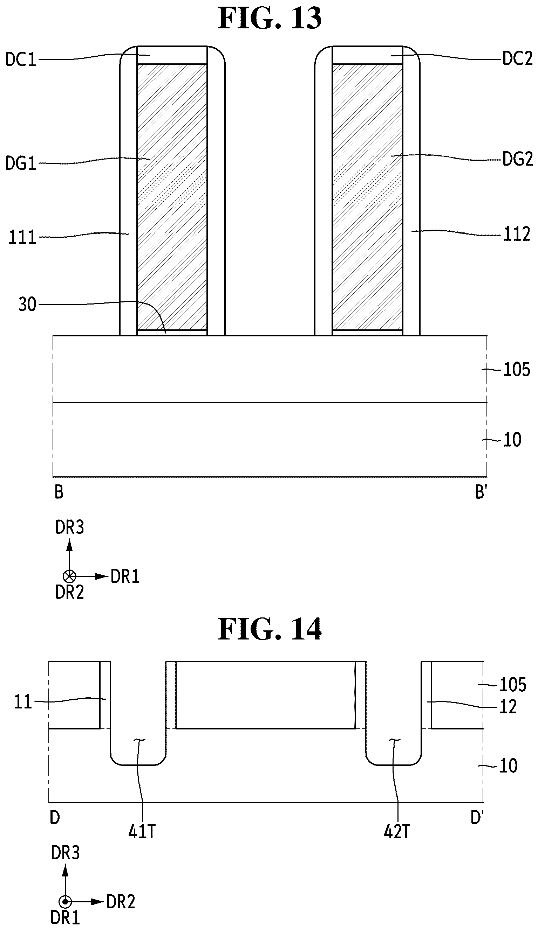

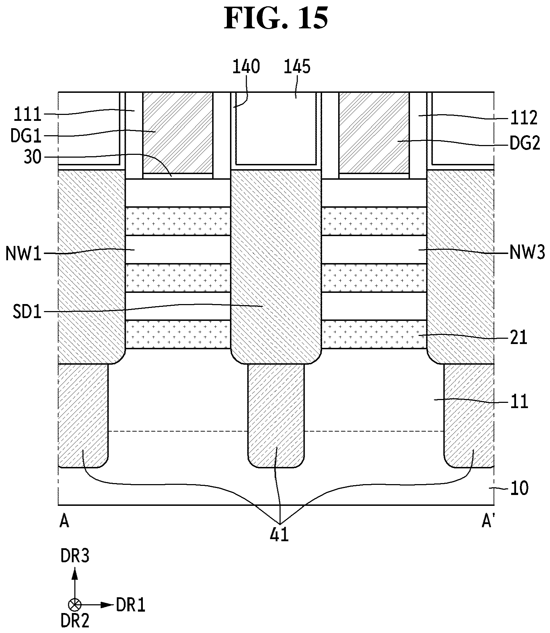

Referring to FIGS. 15 to 17, a first sacrificial pattern 41 may be formed within each first sacrificial pattern trench 41T (see FIGS. 12 and 14), and a second sacrificial pattern 42 may be formed within each second sacrificial pattern trench 42T (see FIG. 14). As an example, each of the first and second sacrificial patterns 41, 42 may include silicon germanium (SiGe). Subsequently, a first source/drain region SD1 may be formed within each first source/drain trench ST1 (see FIG. 12), and a second source/drain region SD2 may be formed within each second source/drain trench. As an example, the lower surface of the first source/drain region SD1 may be in contact with the upper surface of the first sacrificial pattern 41, and the lower surface of the second source/drain region SD2 may be in contact with the upper surface of the second sacrificial pattern 42.

Next, the first etching stop layer 140 may be formed on the exposed surfaces of the exposed field insulating layer 105, the first and second gate spacers 111, 112, the first and second dummy capping patterns DC1, DC2 (see FIGS. 12 and 13), and the first and second source/drain regions SD1, SD2. Subsequently, the first upper interlayer insulating layer 145 may be formed on the first etching stop layer 140. A planarization process may then be performed to expose the upper surfaces of the first and second dummy gates DG1, DG2.

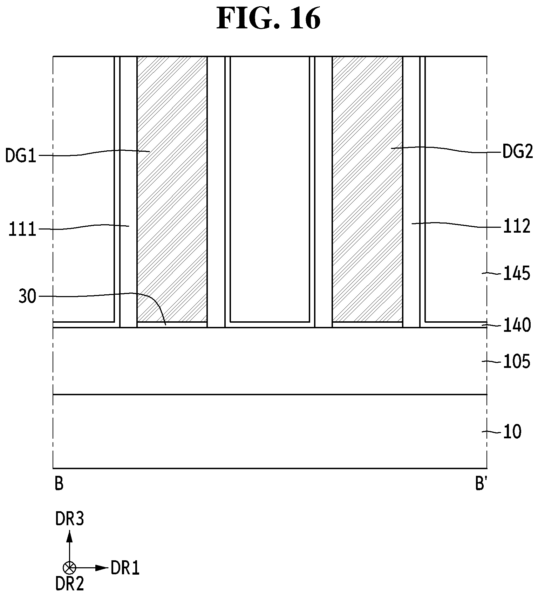

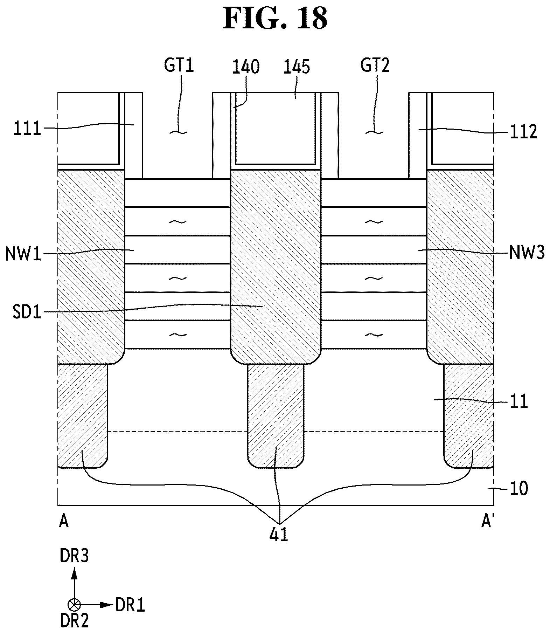

Referring to FIGS. 18 to 20, each of the first and second dummy gates DG1, DG2 (see FIGS. 15 and 16), the pad oxide layer 30 (see FIGS. 15 and 16), and the first semiconductor layer 21 (see FIG. 15) may be etched. A region in which the first dummy gate DG1 (see FIGS. 15 and 16), the pad oxide layer 30 (see FIGS. 15 and 16), and the first semiconductor layer 21 (see FIG. 15) are etched may be defined as a first gate trench GT1. In addition, a region in which the second dummy gate DG2 (see FIGS. 15 and 16), the pad oxide layer 30 (see FIGS. 15 and 16), and the first semiconductor layer 21 (see FIG. 15) are etched may be defined as a second gate trench GT2.

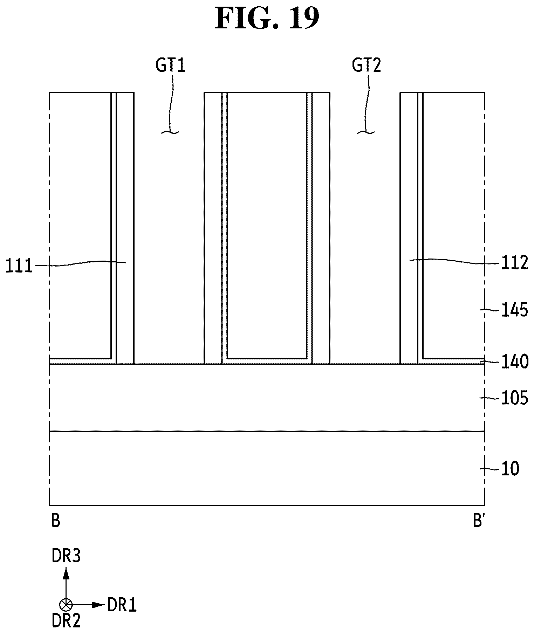

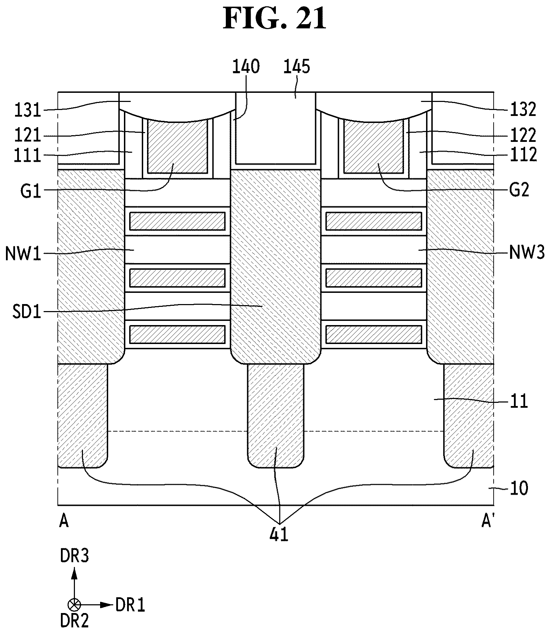

Referring to FIGS. 21 to 23, the first gate insulating layer 121, the first gate electrode G1, and the first capping pattern 131 may be sequentially formed within the first gate trench GT1 (see FIGS. 18 and 19). Each of the first gate electrode G1 and the first capping pattern 131 may extend in the second direction DR2. In addition, the second gate insulating layer 122, the second gate electrode G2, and the second capping pattern 132 may be sequentially formed within the second gate trench GT2 (see FIGS. 18 and 19). Each of the second gate electrode G2 and the second capping pattern 132 may extend in the second direction DR2. As an example, the first gate electrode G1 may surround the first and second pluralities of nanosheets NW1, NW2, respectively. The second gate electrode G2 may surround the third plurality of nanosheets NW3.

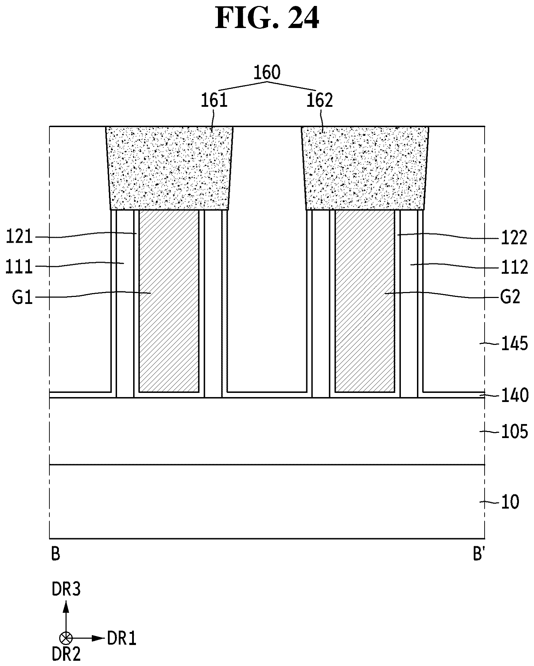

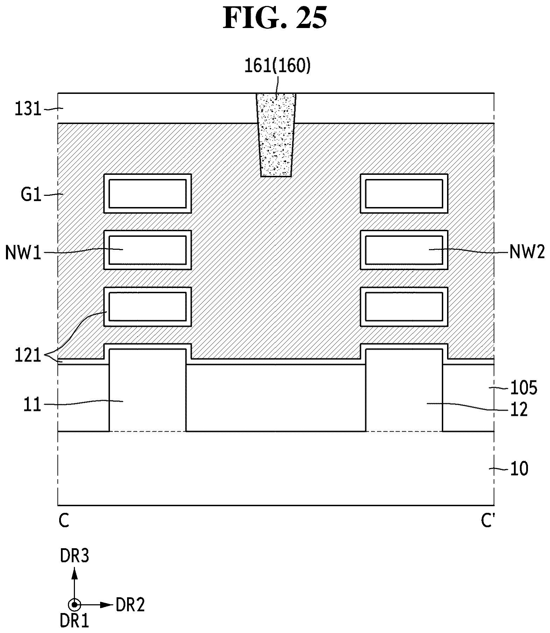

Referring to FIGS. 24 and 25, the upper gate cuts 160 may be formed to penetrate the first and second capping patterns 131, 132 and extend toward the interior of the first and second gate electrodes G1, G2. As an example, the first upper gate cut 161 may be formed to penetrate the first capping pattern 131 and extend toward the interior of the first gate electrode G1. Additionally, the second upper gate cut 162 may be formed to penetrate the second capping pattern 132 and extend toward the interior of the second gate electrode G2. The second upper gate cut 162 may be spaced apart from the first upper gate cut 161 in the first direction DR1. As an example, the first upper gate cut 161 may separate the first capping pattern 131 in the second direction DR2, and the second upper gate cut 162 may separate the second capping pattern 132 in the second direction DR2. The first upper gate cut 161 may partially penetrate the first gate electrode G1. The second upper gate cut 162 may partially penetrate the second gate electrode G2.

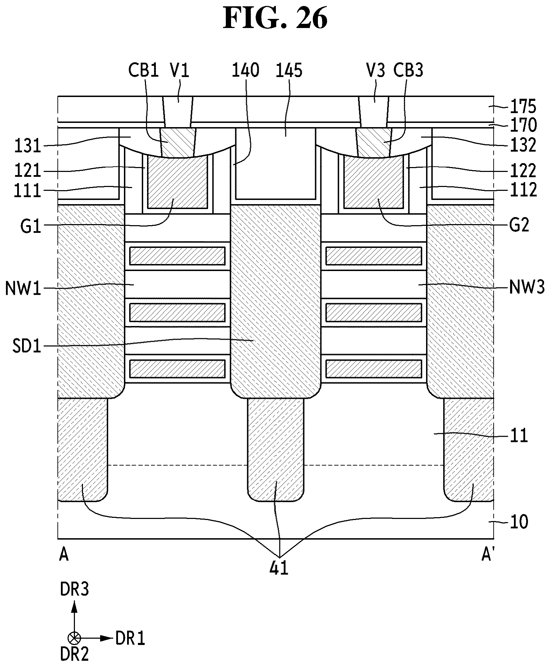

Referring to FIGS. 26 to 29, the first and second gate contacts CB1, CB2 may be formed to penetrate the first capping pattern 131 in the third direction DR3 and be connected to the first gate electrode G1. The first gate contact CB1 is formed on the first sidewall of the first upper gate cut 161 in the second direction DR2, and the second gate contact CB2 may be formed on the second sidewall of the first upper gate cut 161 in the second direction DR2. Additionally, the third gate contact CB3 may be formed to penetrate the second capping pattern 132 in the third direction DR3 and be connected to the second gate electrode G2. In FIGS. 24 to 29, it is shown that the first to third gate contacts CB1, CB2, CB3 are formed after the upper gate cut 160 is formed, but the present disclosure is not limited thereto. In some implementations, the upper gate cut 160 may be formed after the first to third gate contacts CB1, CB2, CB3 are formed.

Subsequently, the second etching stop layer 170 and the second upper interlayer insulating layer 175 may be sequentially formed over the upper surfaces of the first to third gate contacts CB1, CB2, CB3, the first and second capping patterns 131, 132, the first upper interlayer insulating layer 145, and the upper gate cut 160. Thereafter, the first to third vias V1, V2, V3 may be formed to penetrate the second upper interlayer insulating layer 175 and the second etching stop layer 170 in the third direction DR3 and be connected to the first to third gate contacts CB1, CB2, CB3, respectively.

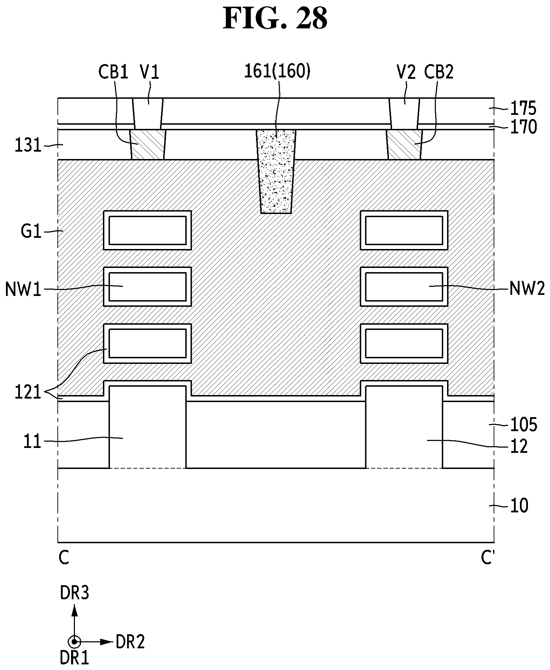

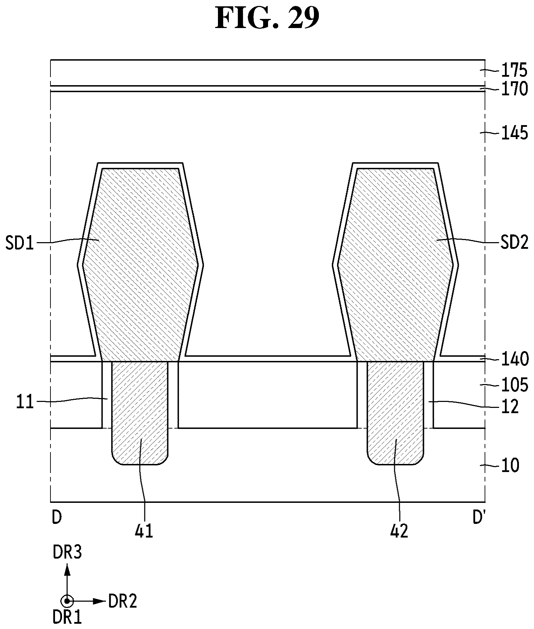

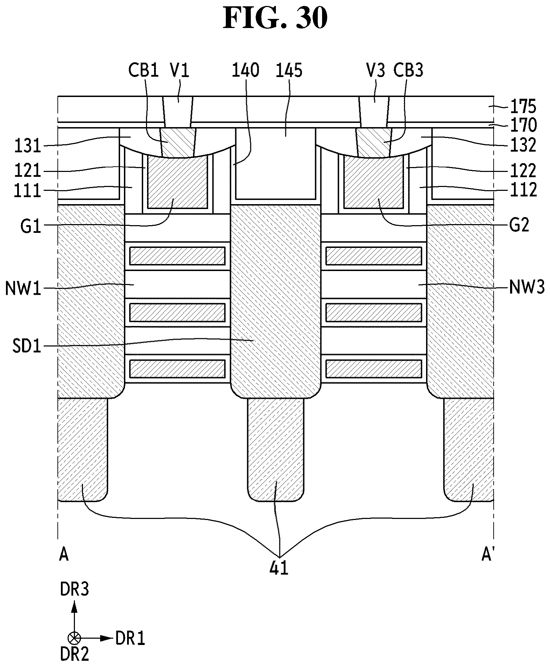

Referring to FIGS. 30 to 33, the substrate 10 (see FIGS. 26 to 29), the first active pattern 11 (see FIGS. 26, 28, and 29), and the second active pattern 12 (see FIGS. 28 and 29) may be etched. For instance, the substrate 10 (see FIGS. 26 to 29), the first active pattern 11 (see FIGS. 26, 28, and 29), and the second active pattern 12 (see FIGS. 28 and 29) may be removed, to expose the lower surface of the field insulating layer 105, the first sacrificial pattern 41 and the second sacrificial pattern 42.

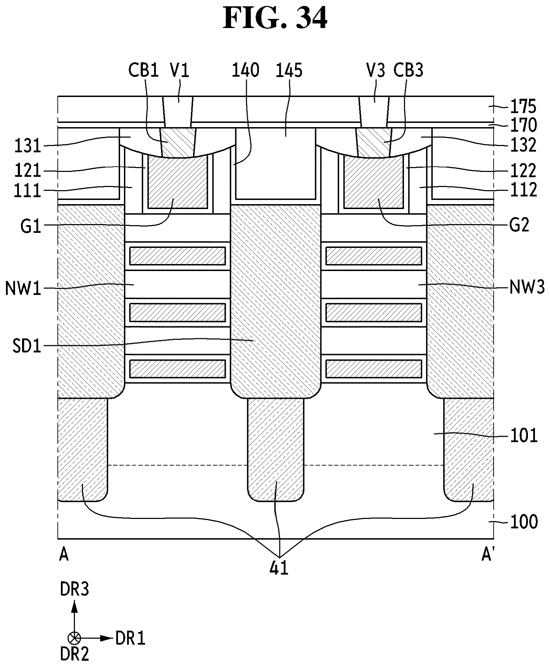

Referring to FIGS. 34 to 37, the first insulating pattern 101 may be formed in the region where the first active pattern 11 (see FIGS. 26, 28, and 29) was etched (e.g., removed), and the second insulating pattern 102 may be formed in the region where the second active pattern 12 (see FIGS. 28 and 29) was etched (e.g., removed). In addition, the first lower interlayer insulating layer 100 may be formed in the region where the substrate 10 (see FIGS. 26 to 29) was etched (e.g., removed).

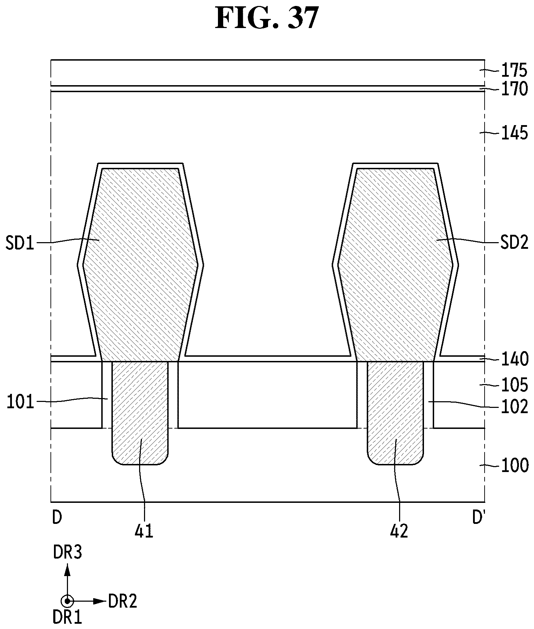

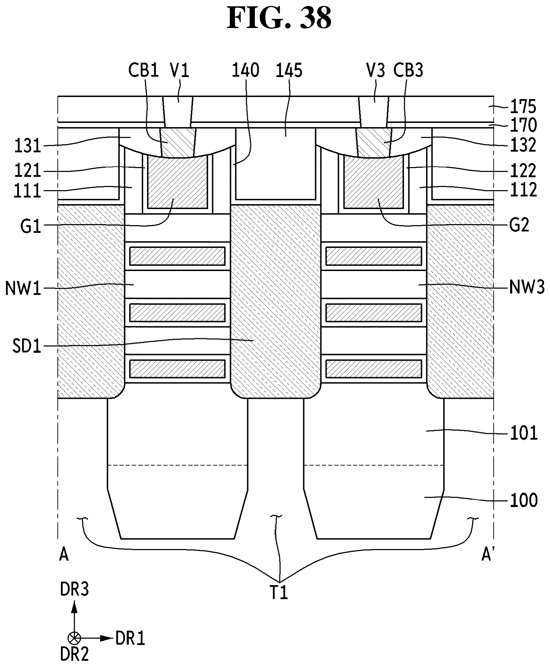

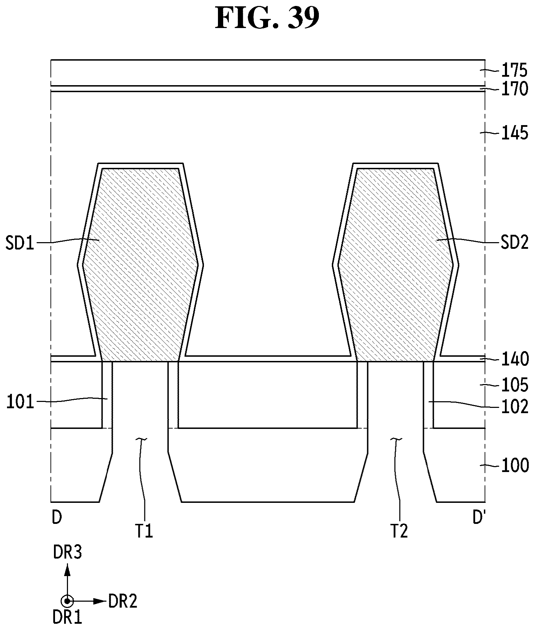

Referring to FIGS. 38 and 39, trenches may be formed within the first lower interlayer insulating layer 100 to expose the lower surfaces of the first and second sacrificial patterns 41, 42 (see FIGS. 34 and 37), respectively. Next, the first and second sacrificial patterns 41, 42 (see FIGS. 34 and 37) may be etched (e.g., removed). As a result, a first contact trench T1 may be formed below each of the plurality of first source/drain regions SD1, and a second contact trench T2 may be formed below each second source/drain region SD2. As an example, the lower surface of each first source/drain region SD1 may be exposed through the first contact trenches T1, and the lower surface of each second source/drain region SD2 may be exposed through the second contact trenches T2.

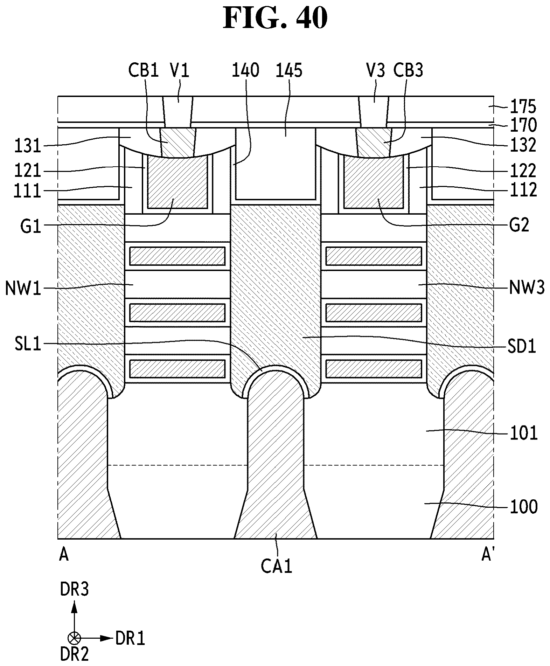

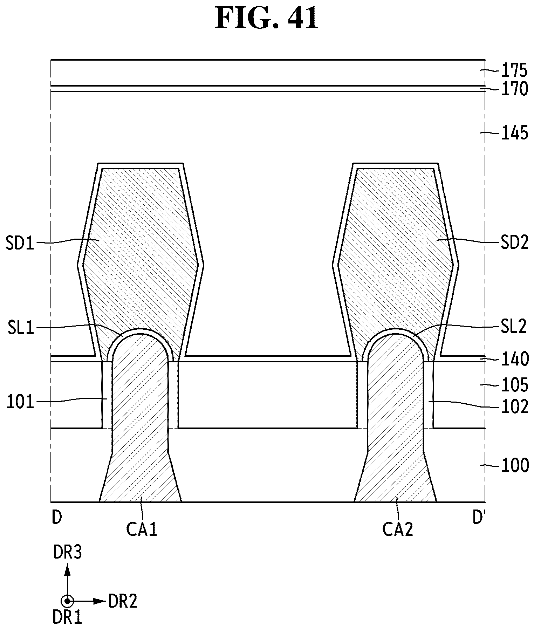

Referring to FIGS. 40 and 41, a portion of each of the first source/drain regions SD1 may be etched through the first contact trenches T1 (see FIGS. 38 and 39), and a portion of each second source/drain region SD2 may be etched through the second contact trenches T2 (see FIG. 39). Subsequently, a first source/drain contact CA1 may be formed within each first contact trench T1 (see FIGS. 38 and 39). At least a portion of the first source/drain contact CA1 may extend into the first source/drain region SD1. In addition, a second source/drain contact CA2 may be formed within each second contact trench T2 (see FIG. 39). At least a portion of the second source/drain contact CA2 may extend into the second source/drain region SD2.The first silicide layer SL1 may be formed along an interface between the first source/drain region SD1 and the first source/drain contact CA1, and the second silicide layer SL2 may be formed along an interface between the second source/drain region SD2 and the second source/drain contact CA2.

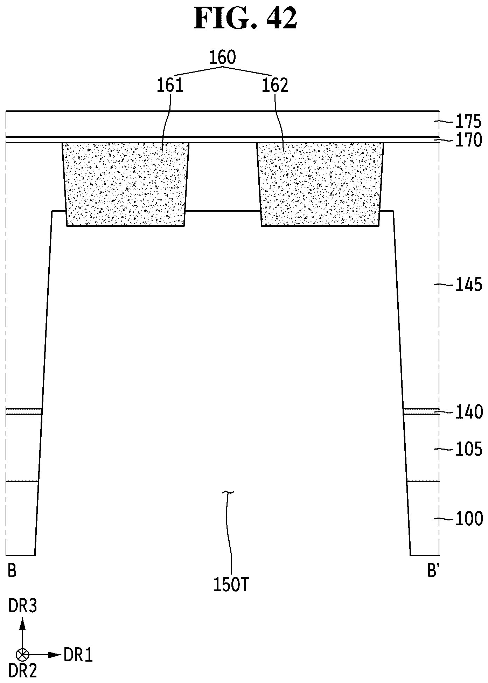

Referring to FIGS. 42 to 44, a gate cut trench 150T extending in the first direction DR1 may be formed between the first insulating pattern 101 and the second insulating pattern 102. The gate cut trench 150T may penetrate the first lower interlayer insulating layer 100, the field insulating layer 105, the first gate insulating layer 121, and the second gate insulating layer 122 in the third direction DR3 and extend into the first and second gate electrodes G1, G2, respectively. In addition, the gate cut trench 150T may penetrate the first lower interlayer insulating layer 100, the field insulating layer 105, and the first etching stop layer 140 in the third direction DR3 and may extend into the first upper interlayer insulating layer 145. As an example, the upper gate cut 160 (e.g., the first and second upper gate cuts 161, 162) may be exposed through the gate cut trench 150T.

Referring to FIGS. 2 to 5, the lower gate cut 150 may be formed within the gate cut trench 150T (see FIGS. 42 to 44). Each of the first and second gate electrodes G1, G2 may be separated in the second direction DR2 by the lower gate cut 150 and the upper gate cut 160. Through such a fabrication process, the semiconductor device illustrated in FIGS. 2 to 5 may be fabricated.

In FIGS. 38 to 44 and FIGS. 2 to 5, the lower gate cut 150 is illustrated as being formed after the first and second source/drain contacts CA1, CA2 are formed. However, the present disclosure is not limited thereto. In some implementations, after the lower gate cut 150 is formed, the second source/drain contacts CA1, CA2 may be formed.

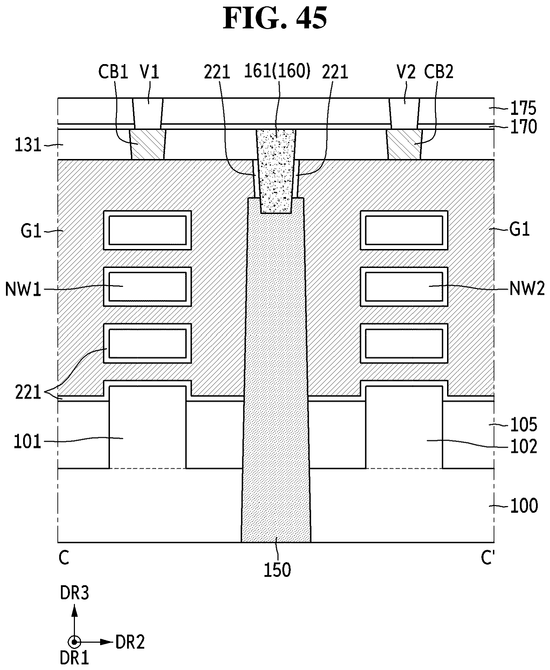

Hereinafter, another example of a semiconductor device will be described with reference to FIG. 45, focusing on differences from the semiconductor device illustrated in FIGS. 1 to 5. FIG. 45 is a cross-sectional view illustrating the further example of a semiconductor device.

Referring to FIG. 45, in some implementations, the first gate insulating layer 221 may be in contact with the sidewall of the upper gate cut 160 in the second direction DR2.

As an example, the first gate insulating layer 221 may be disposed between the first gate electrode G1 and the sidewall of the upper gate cut 160 in the second direction DR2. That is, the first gate electrode G1 may be spaced apart from the sidewall of the upper gate cut 160 in the second direction DR2. As an example, the upper surface of the lower gate cut 150 may be in contact with the first gate insulating layer 221. The first gate electrode G1 may be in contact with the sidewall of the lower gate cut 150 in the second direction DR2.

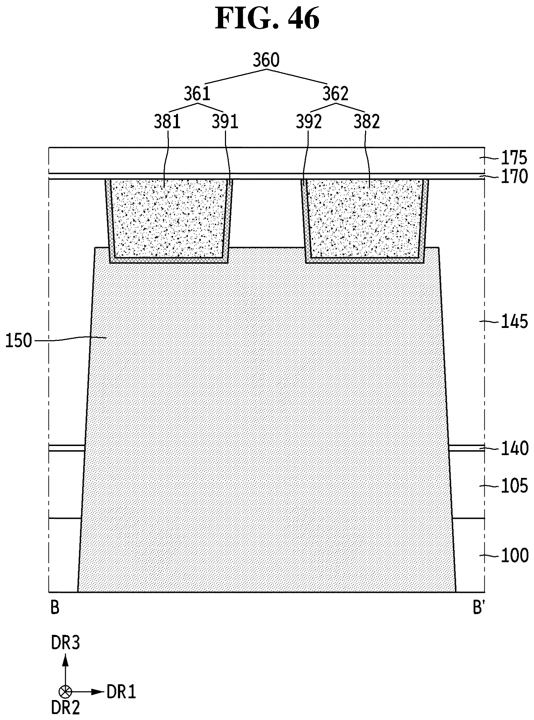

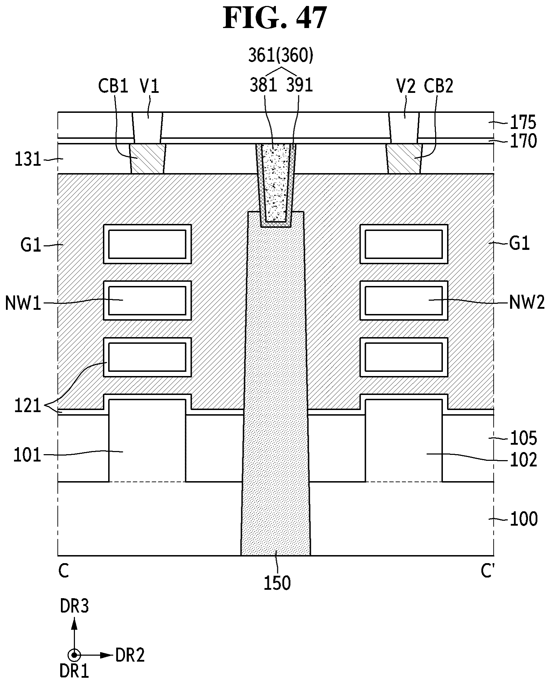

Hereinafter, another example of a semiconductor device according will be described with reference to FIGS. 46 and 47, focusing on differences from the semiconductor device illustrated in FIGS. 1 to 5. FIGS. 46 and 47 are cross-sectional views illustrating the further example of the semiconductor device.

Referring to FIGS. 46 and 47, in some implementations, each of the first upper gate cut 361 and the second upper gate cut 362 may be formed as a dual-layer structure.

As an example, the upper gate cut 360 may include gate cut filling layers 381, 382 and gate cut barrier layers 391, 392. The gate cut barrier layers 391, 392 may be disposed along sidewalls and lower surfaces of the gate cut filling layers 381, 382. The gate cut barrier layers 391, 392 may be in contact with the lower gate cut 150. As an example, the upper gate cut 360 may include the first upper gate cut 361 and the second upper gate cut 362. The second upper gate cut 362 may be spaced apart from the first upper gate cut 361 in the first direction DR1.

As an example, the first upper gate cut 361 may include the first gate cut filling layer 381 and the first gate cut barrier layer 391. The first gate cut barrier layer 391 may be disposed along the sidewall and the lower surface of the first gate cut filling layer 381. The first gate cut barrier layer 391 may be in contact with the lower gate cut 150. As an example, the first gate cut barrier layer 391 may be in contact with each of the first gate electrode G1 and the first capping pattern 131. Similarly, the second upper gate cut 362 may include the second gate cut filling layer 382 and the second gate cut barrier layer 392. The second gate cut barrier layer 392 may be disposed along the sidewall and the lower surface of the second gate cut filling layer 382. The second gate cut barrier layer 392 may be in contact with the lower gate cut 150.

As an example, each of the first and second gate cut filling layers 381, 382 may include at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), and combinations thereof. As an example, each of the first and second gate cut barrier layers 391, 392 may include at least one of aluminum oxide, aluminum nitride, hafnium oxide, zirconium oxide, silicon oxide, silicon nitride, silicon oxynitride, or a low-k dielectric material.

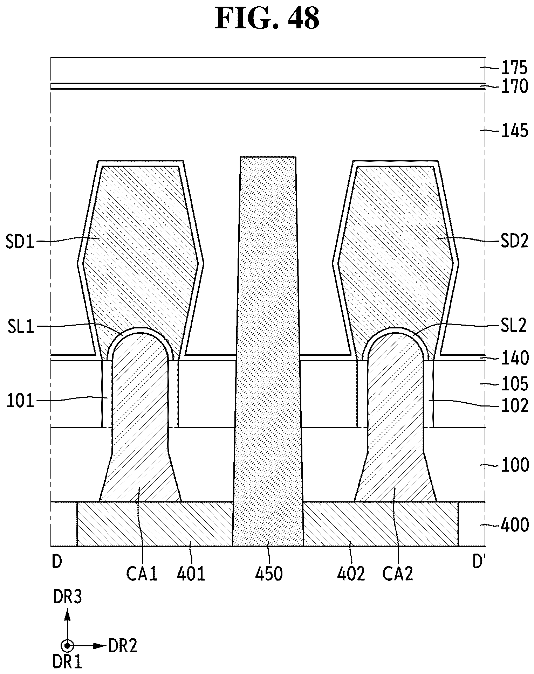

Hereinafter, another example of a semiconductor device will be described with reference to FIG. 48, focusing on differences from the semiconductor device illustrated in FIGS. 1 to 5. FIG. 48 is a cross-sectional illustrating the further example of a semiconductor device.

Referring to FIG. 48, in some implementations, the lower gate cut 450 may separate first and second lower wiring patterns 401, 402 disposed on the lower surface of the first lower interlayer insulating layer 100, from each other in the second direction DR2.

As an example, a second lower interlayer insulating layer 400 may be disposed on the lower surface of the first lower interlayer insulating layer 100. The second lower interlayer insulating layer 400 may be in contact with the lower surface of the first lower interlayer insulating layer 100. As an example, the second lower interlayer insulating layer 400 may include at least one of silicon oxide, silicon nitride, silicon oxynitride, and a low-k dielectric material. As an example, the lower gate cut 450 may penetrate the second lower interlayer insulating layer 400 in the third direction DR3. As an example, the lower surface of the lower gate cut 450 may be formed on the same plane as a lower surface of the second lower interlayer insulating layer 400.

As an example, each of the first and second lower wiring patterns 401, 402 may be disposed within the second interlayer insulating layer 400. The second lower wiring pattern 402 may be spaced apart from the first lower wiring pattern 401 in the second direction DR2. As an example, the first lower wiring pattern 401 may be connected to the first source/drain contact CA1. The second lower wiring pattern 402 may be connected to a second source/drain contact CA2. As an example, the first lower wiring pattern 401 may be in contact with a first sidewall of the lower gate cut 450 in the second direction DR2. The second lower wiring pattern 402 may be in contact with a second sidewall of the lower gate cut 450 in the second direction DR2. Each of the first and second lower wiring patterns 401, 402 may include a conductive material.

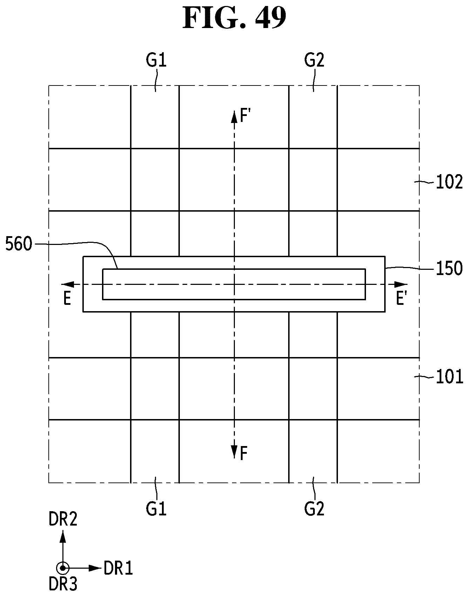

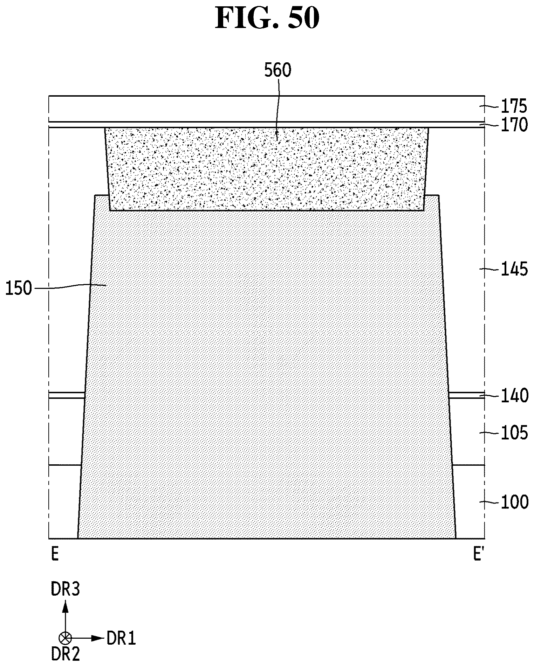

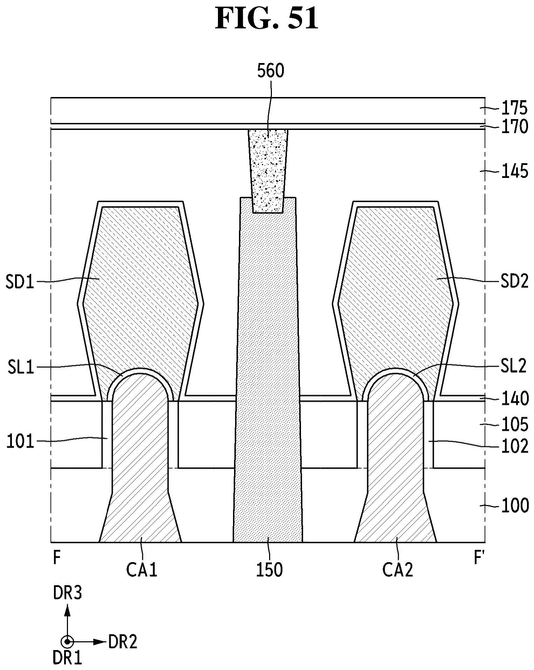

Hereinafter, another example of a semiconductor device will be described with reference to FIGS. 49 to 51. The description will focus on differences from the semiconductor device shown in FIGS. 1 to 5. FIG. 49 is a layout view illustrating the further example of a semiconductor device, and FIG. 50 is a cross-sectional view taken along the line E-E' of FIG. 49. FIG. 51 is a cross-sectional view taken along the line F-F' of FIG. 49.

Referring to FIGS. 49 to 51, in some implementations, the upper gate cut 560 may be formed as an integral structure.

As an example, the upper gate cut 560 may extend in the first direction DR1. The integrally formed upper gate cut 560 may separate the first and second gate electrodes G1, G2 from in the second direction DR2. That is, the upper gate cut 560 may comprise a single, contiguous gate cut that extends in the first direction DR1 across both the first and second gate electrodes G1, G2 to separate each of the first and second gate electrodes G1, G2 into separate portions.

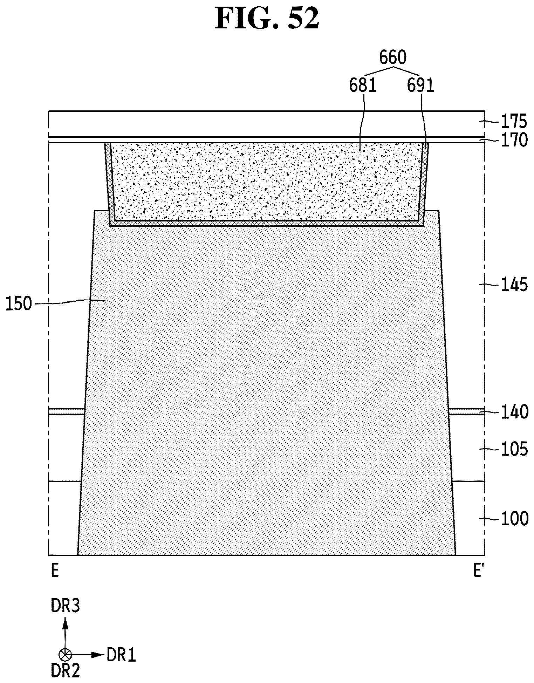

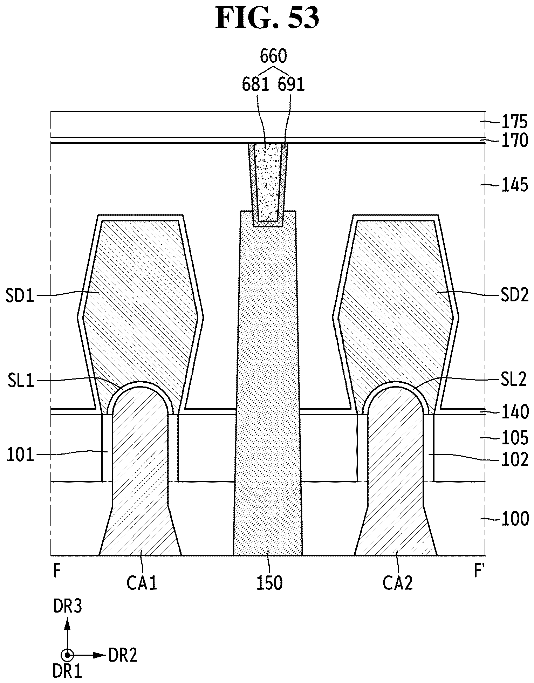

Hereinafter, another example of a semiconductor device will be described with reference to FIGS. 52 to 53. The description will focus on differences from the semiconductor device shown in FIGS. 1 to 5. FIGS. 52 and 53 are cross-sectional views illustrating the further example of a semiconductor device.

Referring to FIGS. 52 and 53, in some implementations, the upper gate cut 660 (e.g., in some implementations, an upper gate cut as described with respect to FIGS. 49 to 51) may be formed as a dual-layer structure.

As an example, the upper gate cut 660 may include the gate cut filling layer 681 and the gate cut barrier layer 691. The gate cut barrier layer 691 may be disposed along the sidewalls and lower surface of the gate cut filling layer 681. The gate cut barrier layer 691 may be in contact with the lower gate cut 150. As an example, the gate cut filling layer 681 may be formed as an integral structure.

As an example, the gate cut filling layer 681 may include at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), and combinations thereof. As an example, the gate cut barrier layer 691 may include at least one of aluminum oxide, aluminum nitride, hafnium oxide, zirconium oxide, silicon oxide, silicon nitride, silicon oxynitride, and a low-k dielectric material.

In accordance with the foregoing description, in some implementations, a method for fabricating a semiconductor device includes: forming first and second active patterns extending in a first direction on an upper surface of a substrate, the second active pattern spaced apart from the first active pattern in a second direction different from the first direction, forming first and second gate electrodes extending in the second direction on the first and second active patterns, the second gate electrode spaced apart from the first gate electrode in the first direction, forming a first capping pattern extending in the second direction on an upper surface of the first gate electrode, and forming a second capping pattern extending in the second direction on an upper surface of the second gate electrode, forming an upper gate cut penetrating each of the first and second capping patterns, the upper gate cut extending into each of the first and second gate electrodes, etching each of the substrate, the first active pattern and the second active pattern, forming a first insulating pattern in an etched portion of the first active pattern, forming a second insulating pattern in an etched portion of the second active pattern, and forming a lower interlayer insulating layer in an etched portion of the substrate, and forming a lower gate cut penetrating the lower interlayer insulating layer in a third direction perpendicular to each of the first and second directions between the first insulating pattern and the second insulating pattern, the lower gate cut extending into each of the first and second gate electrodes, the lower gate cut being in contact with a lower surface of the upper gate cut, at least a portion of the upper gate cut extending in the lower gate cut, wherein each of the first and second gate electrodes is separated in the second direction by the lower gate cut and the upper gate cut.

According to some implementations, there is provided a method for fabricating a semiconductor device, wherein the lower surface of the upper gate cut is formed lower than an uppermost surface of the lower gate cut.

According to some implementations, there is provided a method for fabricating a semiconductor device, wherein a width of the lower surface of the upper gate cut in the first direction is smaller than a width of the uppermost surface of the lower gate cut in the first direction.

According to some implementations, there is provided a method for fabricating a semiconductor device, wherein forming the first gate electrode includes forming a first plurality of nanosheets spaced apart from each other in the third direction and stacked on an upper surface of the first active pattern, and forming a second plurality of nanosheets spaced apart from each other in the third direction and stacked on an upper surface of the second active pattern, and forming the first gate electrode surrounding each of the first and second pluralities of nanosheets.

According to some implementations, there is provided a method for fabricating a semiconductor device, wherein the upper gate cut includes a first upper gate cut separating the first gate electrode in the second direction, and a second upper gate cut separating the second gate electrode in the second direction, the second upper gate cut spaced apart from the first upper gate cut in the first direction, and wherein a lower surface of each of the first and second upper gate cuts is in contact with the lower gate cut.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While certain examples have been particularly shown and described, it will be understood that various changes in form and details may be made therein without departing from the scope of this disclosure.

## Claims

1. A semiconductor device comprising:
a first lower interlayer insulating layer (100);
a first insulating pattern (101) extending in a first direction on an upper surface of the first lower interlayer insulating layer (100);
a second insulating pattern (102) extending in the first direction on the upper surface of the first lower interlayer insulating layer (100), the second insulating pattern (102) being spaced apart from the first insulating pattern (101) in a second direction different from the first direction;
a first plurality of nanosheets (NW1) spaced apart from each other along a third direction perpendicular to each of the first and second directions, wherein the first plurality of nanosheets (NW1) are on an upper surface of the first insulating pattern (101);
a second plurality of nanosheets (NW2) spaced apart from each other along the third direction, wherein the second plurality of nanosheets (NW2) are on an upper surface of the second insulating pattern (102), and wherein the second plurality of nanosheets (NW2) are spaced apart from the first plurality of nanosheets (NW1) along the second direction;
a first gate electrode (G1) extending in the second direction on the first and second insulating patterns (101, 102), wherein the first plurality of nanosheets (NW1) and the second plurality of nanosheets (NW2) are in the first gate electrode (G1);
a lower gate cut (150) between the first insulating pattern (101) and the second insulating pattern (102), the lower gate cut (150) extending through the first lower interlayer insulating layer (100) in the third direction and extending in the first gate electrode (G1); and
an upper gate cut (160) having a lower surface in contact with the lower gate cut (150), the upper gate cut (160) extending in the first gate electrode (G1) in the third direction,
wherein an upper surface of the upper gate cut (160) is higher than an upper surface of the first gate electrode (G1), wherein at least a portion of the upper gate cut (160) extends in the lower gate cut (150), and
wherein portions of the first gate electrode (G1) are spaced apart from one another along the second direction by the lower gate cut (150) and the upper gate cut (160).

2. The semiconductor device of claim 1, wherein the lower surface of the upper gate cut (160) is lower than an uppermost surface of the lower gate cut (150).

3. The semiconductor device of claim 1 or claim 2, comprising:
a second gate electrode (G2) extending in the second direction on the first and second insulating patterns (101, 102), the second gate electrode (G2) being spaced apart from the first gate electrode (G1) along the first direction,
wherein portions of the second gate electrode (G2) are spaced apart from one another along the second direction by the lower gate cut (150) and the upper gate cut (160).

4. The semiconductor device of claim 3, wherein the upper gate cut (160) comprises:
a first upper gate cut (161) spacing apart the portions of the first gate electrode (G1); and
a second upper gate cut (162) spacing apart the portions of the second gate electrode (G2), the second upper gate cut (162) being spaced apart from the first upper gate cut (161) in the first direction, and
wherein respective lower surfaces of each of the first and second upper gate cuts (161, 162) are in contact with the lower gate cut (150).

5. The semiconductor device of claim 4, comprising:
an upper interlayer insulating layer (145) in contact with sidewalls of the lower gate cut (150) opposing one another along the first direction, sidewalls of the first upper gate cut (161) opposing one another along the first direction, and sidewalls of the second upper gate cut (162) opposing one another along the first direction,
wherein, between the first upper gate cut (161) and the second upper gate cut (162), the upper interlayer insulating layer (145) is in contact with an upper surface of the lower gate cut (150).

6. The semiconductor device of any preceding claim, wherein a width of the lower surface of the upper gate cut (160) in the first direction is smaller than a width of an uppermost surface of the lower gate cut (150) in the first direction.

7. The semiconductor device of any preceding claim, wherein a width of the lower surface of the upper gate cut (160) in the second direction is smaller than a width of an uppermost surface of the lower gate cut (150) in the second direction.

8. The semiconductor device of any preceding claim, comprising:
a source/drain region (SD1) on one side of the first gate electrode (G1) on the upper surface of the first insulating pattern (101); and
a source/drain contact (CA1) below the source/drain region (SD1), wherein the source/drain contact (CA1) extends through the first lower interlayer insulating layer (100) and the first insulating pattern (101) in the third direction, and wherein the source/drain contact (CA1) is connected to the source/drain region (SD1), and
wherein the lower gate cut (150) is spaced apart from the source/drain contact (CA1) in the second direction.

9. The semiconductor device of any preceding claim, comprising:
a capping pattern (131) extending in the second direction on the upper surface of the first gate electrode (G1),
wherein the capping pattern (131) is in contact with the upper surface of the first gate electrode (G1),
wherein an upper surface of the capping pattern (131) is on a same plane as the upper surface of the upper gate cut (160), and
wherein portions of the capping pattern (131) are spaced apart from one another along the second direction by the upper gate cut (160).

10. The semiconductor device of any preceding claim, wherein the first gate electrode (G1) is in contact with a sidewall of the lower gate cut (150) and a sidewall of the upper gate cut (160).

11. The semiconductor device of any of claims 1-9, comprising:
a gate insulating layer (221) between the first gate electrode (G1) and the first plurality of nanosheets (NW1), and between the first gate electrode (G1) and the upper gate cut (160),
wherein the first gate electrode (G1) is in contact with a sidewall of the lower gate cut (150).

12. The semiconductor device of any preceding claim, wherein the upper gate cut (360) comprises:
a gate cut filling layer (381, 382); and
a gate cut barrier layer (391, 392) in contact with a sidewall and a lower surface of the gate cut filling layer (381, 382), wherein the gate cut barrier layer is (391, 392) in contact with the lower gate cut (150).

13. The semiconductor device of any preceding claim, wherein a width of an uppermost surface of the lower gate cut (150) in the first direction is smaller than a width of a lower surface of the lower gate cut (150) in the first direction, and
wherein a width of the lower surface of the upper gate cut (160) in the first direction is smaller than a width of the upper surface of the upper gate cut (160) in the first direction.

14. The semiconductor device of any preceding claim, wherein an uppermost surface of the lower gate cut (150) is higher than an upper surface of an uppermost nanosheet of the first plurality of nanosheets (NW1).

15. The semiconductor device of any preceding claim, comprising:
a second lower interlayer insulating layer (400) on a lower surface of the first lower interlayer insulating layer (100);
a first lower wiring pattern (401) in the second lower interlayer insulating layer (400), wherein the first lower wiring pattern (401) is in contact with a first sidewall of the lower gate cut (450) facing along the second direction; and
a second lower wiring pattern (402) in the second lower interlayer insulating layer (400), wherein the second lower wiring pattern (402) is in contact with a second sidewall of the lower gate cut (450) facing along the second direction, and wherein the second lower wiring pattern (402) is spaced apart from the first lower wiring pattern (401) along the second direction.
